(19) Europäisches Patentamt
European Patent Office
Office européen des brevets

(11) EP 4 369 098 A1

(12) EUROPEAN PATENT APPLICATION

(43) Date of publication:
15.05.2024 Bulletin 2024/20

(21) Application number: 22020552.0

(22) Date of filing: 14.11.2022

(51) International Patent Classification (IPC):
*G03F 7/00* (2006.01) *B33Y 70/00* (2020.01)
*G03F 7/027* (2006.01) *G03F 7/038* (2006.01)

(52) Cooperative Patent Classification (CPC):
**G03F 7/027; B33Y 70/10; G03F 7/0037; G03F 7/038**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Cubicure GmbH**
**1230 Wien (AT)**

(72) Inventors:
- **GORSCHE, Christian**
**A-1140 Vienna (AT)**
- **FRANK, Christian**
**A-1230 Vienna (AT)**
- **LEITNER, Michael**
**A-1100 Vienna (AT)**

(74) Representative: **Keschmann, Marc**
**Haffner und Keschmann Patentanwälte GmbH**
**Schottengasse 3a**
**1010 Wien (AT)**

# (54) RESIN COMPOSITION

(57) A resin composition for the 3D-printing of objects, comprising a light-curable component A functioning as 3D-structurable matrix, a component B functioning as a synergistic combination of flame retardants, and at least one photoinitiator suitable for polymerization upon light excitation, wherein, based on the total combined weight of components A and B, the amount of the curable component A ranges from 60 wt% to 95 wt%, preferably from 65 wt% to 90 wt%, more preferably from 70 wt% to 85 wt%, the amount of the flame-retardant component B, based on the total weight of components A and B, ranges from 5 wt% to 40 wt%, preferably from 10 wt% to 35 wt%, more preferably from 15 wt% to 30 wt%, and, based on the weight of component A alone, the amount of the photoinitiator ranges from 0.01 wt% to 10 wt%.

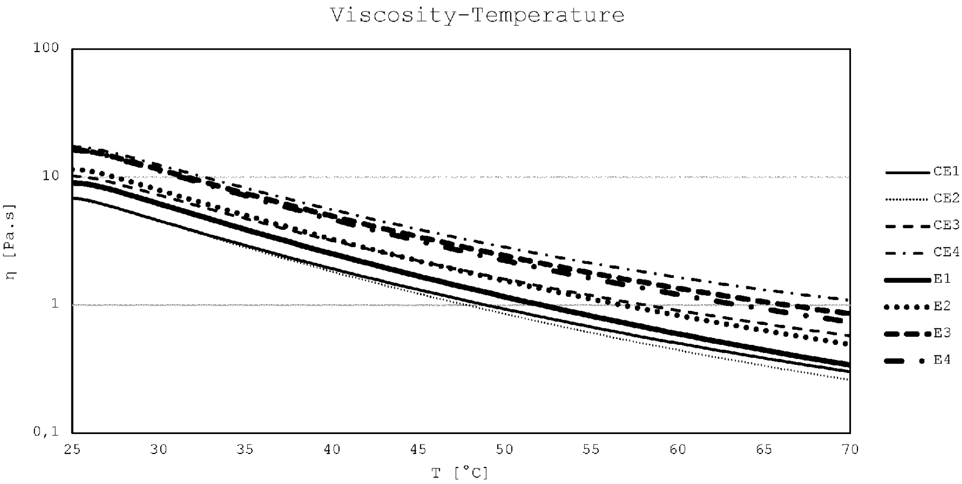


Viscosity-temperature behaviour for comparative examples CE1-CE4 and examples E1-E4.

Fig. 1



Processed by Luminess, 75001 PARIS (FR)

## Description

### Field of the invention

The present invention relates to a resin composition for the 3D-printing of objects having flame-retardant properties and favourable (thermo)mechanical properties. Further, the invention relates to a method of manufacturing an object by 3D-printing from the inventive resin composition and to an object manufactured from the inventive resin composition.

### Introduction

With the upcoming industrialization of 3D-printing, the use and availability of flame-retardant 3D-printing materials is becoming more and more important. Especially for lithography-based 3D-printing processes or lithography-based additive manufacturing technologies (L-AMTs) the availability of such flame-retardant materials is still very limited, since these technologies are particularly characterized by their high precision and manufacturing accuracy in the micrometer range making components with wall thicknesses < 4 mm of enormous relevance. The materials used must, therefore, maintain their flame-retardant effect even with small wall thicknesses, something that current commercial material solutions have not yet been able to provide.

Light-curable materials (resins or formulations) for L-AMTs are typically composed of reactive components (e.g., monomers, oligomers and photoinitiators) that polymerize and cure upon light irradiation and of certain additives that further adjust the overall material performance (e.g., fillers or process additives). Typically, the photoinitiator is activated via light irradiation and generates a reactive site (e.g., a radical, cation or anion) that can then react with the respective reactive components (e.g., (meth)acrylates, (meth)acrylamides, vinyl esters, vinyl ethers, vinyl amides, N-vinyl compounds, vinyl carbonates, vinyl carbamates, maleimides, itaconates, fumarates, styrene compounds, cyclic ethers such as epoxy compounds or oxetanes, benzoxazines, oxazolines, cyanoacrylates) to form a cured material.

(Meth)acrylate-based resins for lithography-based 3D-printing traditionally exhibit low fire resistance, which crucially limits their use as materials in industrial fields such as the mobility sector, e.g., automotive, railway systems, aerospace, or the electronics industry, their use for components for industrial applications, household appliances, LED lighting technology, consumer and home electronics, power tools, applications for connectors, switches, plugs, PC fans, structural and housing components, smartphones, washing machines, airplane parts, and the like.

Some technological solutions to improve flame retardancy in the field of L-AMTs are already known.

WO 2020/055682 A1 (Carbon, Inc.) discloses a dual-cure resin composition for manufacturing a flame-retardant 3D component using stereolithography (SLA) (e.g., continuous liquid interface production), WO 2019/130306 A1 (Bromine Compounds LTD.) discloses flame-retardant photo-curable formulations and WO 2013/189821 A1 (Allnex) discloses a flame-retardant radiation-curable composition. These referenced flame-retardant materials consist of halogenated resin components.

Also, CN 112940189 A discloses a flame-retardant photosensitive resin composition and methods for its production and use. The flame-retardant photosensitive resin composition comprises the following components in parts by weight: 20-50 parts of photosensitive resin, 20-50 parts of reactive diluent, 5-15 parts of flame retardant, 1-5 parts of photoinitiator, and 0.1-2.0 parts of other additives; The flame retardant comprises a combination of a phenyl phosphorus flame retardant and a brominated alkyl flame retardant. Thus, the flame-retardant material consists of halogenated resin components.

Flame retardants receive increasing scientific and public attention. Discussions about flame retardants started, when some brominated flame retardants (BFRs) became a topic of environmental concern in the early 1990s. It was discovered that some BFRs could form halogenated dioxins and furans under severe thermal stress or when they were burnt in accidental fires or uncontrolled combustion. Further findings in the environment and biota and the suspicion that some BFRs bio-accumulate in organisms have added to these concerns. Meanwhile, the environmental and health properties of not only BFRs but also other types of flame retardants have been studied extensively such as to determine which flame retardants, regardless of their chemistry, could give a valid alternative in terms of efficacy and environmental fates.

Considered sustainable and environmentally friendly flame-retardant alternatives to halogenated flame retardants are typically inorganic flame retardants (e.g., aluminum hydroxide, magnesium hydroxide, calcium hydroxide, antimony oxide, tin oxide, borax, expandable graphite and zinc borate), phosphorous-based flame retardants (e.g., organic and inorganic phosphates, phosphonates and phosphinates, as well as red phosphorus) or nitrogen-based flame retardants (e.g., melamine and melamine derivatives such as melamine cyanurate, melamine phosphate, melem, melon).

CN 105068378 A discloses a flame-retardant photosensitive SLA-resin for 3D-printing. The disclosed photosensitive resin consists of the following components (by weight): phosphorus-containing acrylate prepolymer 15-75%, acrylate 15-75%, free radical initiator 1-5%, auxiliary agent 0.5-2%, reactive diluent 5-15%, with the total weight percentage of the above components being 100%. The disclosed photosensitive phosphorus-containing acrylate prepolymer has a flame-retardant effect, and better flame retardancy can be achieved by adding a relatively high amount of this prepolymer.

CN 102827332 A discloses an ultraviolet-curing, transparent, halogen-free, flame-retardant unsaturated polyester and a process for producing the same. The disclosed unsaturated polyester is defined in weight percent, and the formula for the raw material is 49.5%-65% unsaturated phosphorus-boron flame-retardant polyester-prepolymer, 50% to 30% reactive diluent, 0.4% to 4.5% photoinitiator and 0.1% to 0.5% polymerization inhibitor. The unsaturated phosphorus-containing flame-retardant polyester prepolymer is composed of glycols and unsaturated dibasic acid anhydrides and/or unsaturated dibasic carboxylic acids, phosphaphenanthrene anhydride derivatives and boric acid obtained by reaction at 150 - 205 °C. The disclosed unsaturated polyester has a volatilization loss rate of less than 1% during the curing process, and is, therefore, considered advantageous in terms of low volatilization loss, halogen-free flame retardancy, transparency and the like. However, the content of flame retardant in the described unsaturated polyester is relatively high, and the requirements for the manufacturing process are relatively high.

KR 20210104367 A discloses a flame-retardant composition for post-coating digitally printed matter such as photo prints. The composite flame retardant comprises an inorganic phosphorus flame retardant such as red phosphorus, ammonium phosphate or ammonium polyphosphate and an organic phosphorus flame retardant such as an aromatic phosphate or haloalkyl phosphate. In KR 20210104367 A, it is important to use the composite flame retardant in a weight ratio of inorganic phosphorus flame retardant: organic phosphorus flame retardant = 1 : 0.1-10, especially 1 : 0.5-5. In KR 20210104367 A, when the weight ratio is less than 1:0.1, the homogeneity, adhesion and flexibility of the flame-retardant layer of the coating are lower, and there is a risk that the flame-retardant layer will fall off due to cracking caused by external harmful influences such as wind and rain. When the weight ratio exceeds 1 : 10, the flame retardancy of the coating according to KR 20210104367 A is improved, but there is a concern that the flame retardancy is no longer adequate.

In CN 113637118 A, phosphinates and polyphosphates are combined in a photopolymer resin and used in amounts of about 10-40 wt% of the total resin. This results in a high temperature-resistant, halogen-free, flame-retardant photosensitive 3D-printing resin. However, CN 113637118 A neither addresses synergistic mixing ratios and advantageous flame-retardant combinations in terms of combined flame retardancy and (thermo)mechanical performance, nor does it refer to the nature and design of the flame-retardant additives or resin matrix.

Processing of light-curable formulations into 3D-objects can be performed via various L-AMTs with non-limiting examples being stereolithography (SLA), digital light processing (DLP), digital inkjet printing, Hot Lithography, continuous liquid interface production (CLIP), high-area rapid printing (HARP), multijet modeling, two photon photopolymerization (TPP) or other liquid additive manufacturing technologies. The mentioned technologies are mostly based on a layer-by-layer build-up of the final 3D-object and can be realized in various forms such as bottom-up or top-down, in a continuous fashion, and/or by using moving-digital light processing (DLP) or laser-type systems for larger printing areas. Current resin formulations applied for such technologies are almost exclusively of low viscosity (< 1 Pa·s, measured according to DIN EN ISO 2884-1, DIN EN ISO 2884-2, or in accordance with the procedure described herein), which is imperative for a successful build-up job or build-up step and ensures high feature resolution and prevents processing defects.

Applicant has developed the Hot Lithography Process (EP 3284583 A1), which allows for lithography-based 3D-stucturing at elevated temperatures of light-curable resins having high viscosities of typically > 1 Pa·s at ambient temperature (20 °C). In the context of EP 3284583 A1, high viscosities are to be found when processing light-curable resins having high contents of monomers, oligomers and/or prepolymers with high molecular weight of more than 500 g/mol, preferably more than 2000 g/mol and/or high melting or softening temperatures (> 35 °C) and/or strong intermolecular forces (e.g., urethanes, ureas, carbonates, esters, amides) and/or high contents of filling materials (e.g., ceramic, metal and/or polymer particles and/or fibers) that are added to the light-curable resins in order to optimize the performance of the finally cured material. The combination of high temperatures and processing of highly viscous resin formulations enables the 3D-structuring of light-curable materials with combined flame resistance, toughness, heat resistance and impact resistance.

Recently, a strong focus has been put on hybrid resin systems composed of one or more additional material component(s) different from the material component(s) used in the photopolymer network formation via the light-structuring step of L-AMTs. Such promising hybrid material concepts show great potential for the formation of tough photopolymer resins for additive manufacturing and yield photopolymerized materials with simultaneously high toughness and heat resistance. Hybrid resin systems can be defined as resin materials that undergo various curing steps triggered by different impulses (e.g., a light-curing step followed by a subsequent heat-curing step such as in EP 4049841 A1 or US 2016/0160077 A1) and/or materials that exhibit multiple hardening mechanisms (e.g., combined radical and cationic curing mechanisms or various radical curing mechanisms triggered in a subsequent manner such as in WO 2016/200972 A1 or WO 2018/191247 A1). Such formed photopolymer networks are considered hybrid materials composed of a first component and a second component or multiple further components and typically represent a full interpenetrating network (IPN), a semi-IPN, a pseudo-IPN, a dual network or a polymer blend. In order to maintain reactivity toward light, thus to

ensure processability in L-AMTs, resins need to be formulated with an effective content of light-curable components to yield materials with sufficient green strength. Green strength is the mechanical strength (e.g., measured by tensile test in accordance with DIN EN ISO 527 or bending test in accordance with DIN EN ISO 178) a respective material has after only the light-curing additive manufacturing step before undergoing an additional heat-curing manufacturing step.

Materials formed from such hybrid resins via different curing mechanisms through a first light-curing step and a second or multiple further curing steps different from said first light-curing step, offer a powerful design strategy for performance photopolymers with simultaneously high toughness and heat resistance and are also a promising concept for the design of flame-resistant photopolymers. Said second or multiple further curing steps can be performed either simultaneously with or subsequently to the initial light-curing step (e.g., structuring step in L-AMTs). Examples of said second or multiple further curing steps are:

i) heat-curing steps triggering the thermal curing of the resin parts that have not been cured via the first light-curing step (e.g., thermal curing of an epoxy thermoset within an acrylate matrix),
ii) curing steps catalyzed by moisture or organic catalysts triggering the curing of the resin parts that have not been cured via the first light-curing step (e.g., curing of resins with free isocyanate- or silane-groups) and/or curing steps that first trigger the decomposition of resin moieties, which then subsequently trigger the curing of the resin parts that have not been cured via the first light-curing step (e.g., curing and/or deblocking of resins with blocked isocyanate-groups),
iii) light-curing steps triggering a different curing mechanism than in the first light-curing step to initiate curing of the resin parts that have not been cured via the first light-curing step (e.g., acrylate/epoxy resin systems cured via radical and cationic photopolymerization),
iv) light-curing steps triggered by a different wavelength from the first light-curing step to initiate curing of the resin parts that have not been cured via the first light-curing step (e.g., acrylate resin part cured at wavelengths > 390 nm and epoxy resin part cured at wavelengths < 380 nm).

In summary, it appears to be very important to develop a flame-retardant photosensitive resin with a relatively small amount of flame retardant that provides good flame-retardant effects that still allows for an efficient and stable 3D-printing manufacturing process. In addition, for the resulting product, the final (thermo)mechanical material parameters must also be considered.

## Description of the Invention

In order to solve this objective, the present invention provides a resin composition for the 3D-printing of objects with high flame resistance, comprising:

a) a curable component A comprising one or more light-curable components chosen from group I consisting of (meth)acrylates, (meth)acrylamides, vinyl esters, vinyl ethers, vinyl amides, N-vinyl compounds, vinyl carbonates, vinyl carbamates, maleimides, itaconates, fumarates, styrene compounds, cyclic ethers such as epoxy compounds or oxetanes, benzoxazines, oxazolines, and cyanoacrylates, said one or more light-curable components chosen from group I forming a first polymerized network;
b) a flame-retardant component B being a combination of i) at least one of a nitrogen donor and a polyphosphate and a polyphosphonate and ii) one or more inorganic phosphinate salts, wherein the weight ratio of i) to ii) is preferably between 1/9 and 9/1; and
c) at least one photoinitiator suitable for polymerization upon light excitation,

wherein, based on the total combined weight of components A and B, the amount of the curable component A ranges from 60 wt% to 95 wt%, preferably from 65 wt% to 90 wt%, more preferably from 70 wt% to 85 wt%, the amount of the flame-retardant component B, based on the total combined weight of components A and B, ranges from 5 wt% to 40 wt%, preferably from 10 wt% to 35 wt%, more preferably from 15 wt% to 30 wt%, and, based on the weight of component A alone, the amount of the photoinitiator ranges from 0.01 wt% to 10 wt%.

The core of the invention, therefore, relates to a resin composition for the 3D-printing of articles with flame-retardant properties and improved (thermo)mechanical properties. Here, an advantageous combination of inorganic and organic flame-retardant additives, in solid and/or liquid form, with phosphorus-content and/or nitrogen-content is used to enable both processability of the inventive resin composition in a 3D printer (potentially with a targeted filler design comprising a particle size of the filler in the range 0.1-100 $\mu$m D50 value and/or liquid oligomers to reduce "softening effect") and to ensure optimized (thermo)mechanical performance (e.g., minimum required flame-retardant content in the range of 5-40 wt% based on the total weight of the curable component A and the flame-retardant component B).

By the present invention, optimized flame-retardant formulations of photocurable resins for lithography-based

3D-printing processes have been found, which allow for the design and production of flame-retardant materials with wall thicknesses down to < 4 mm, even down to < 1.5 mm, and which at the same time allow for improved (thermo)mechanical properties compared to available flame-retardant photopolymer materials (e.g., $T_g$ > 90 °C - The glass transition temperature $T_g$ is typically derived via dynamic mechanical analysis (DMA) from the maximum value of the loss factor plot (tan $\delta$), elongation at break > 3%). The inventive formulations are composed of halogen-free substances and in particular halogen-free flame-retardant substances, which is critical for achieving sustainable and environmentally safe flame-retardant resin formulations and products.

According to a preferred embodiment of the present invention, component A further comprises one or more heat-curable components chosen from group II consisting of mono- or multifunctional components, forming a second polymerized network with a $T_g$ > 100 °C, serving as a $T_g$-enhancer (TGE), wherein in component A, based on the total weight of the components of group I and group II, the amount of the one or more components of group II ranges from 1 to 50 wt%, preferably from 2 wt% to 40 wt%, more preferably from 3 wt% to 30 wt%, even more preferably from 5 wt% to 25 wt%, and the amount of the one or more components of group I ranges from 50 wt% to 99 wt%. By introducing such components from group II, hybrid resins via different curing mechanisms through a first light-curing step (group I) and a second or multiple further curing steps different from said first light-curing step (group II), are introduced. This yields performance photopolymers with simultaneously high toughness and heat resistance.

In the context of the present application, the temperature $T_g$ of a specific component or a specific combination of components is the glass transition temperature derived via DMA typically from the maximum of the tan$\delta$ plot of the network that forms from this component alone or this combination of components alone without other networks, polymer backbones or sub-networks. The tan $\delta$ plot is recorded in accordance with the DMA method described herein.

Preferably, component A consists of the one or more components chosen from group I and optionally the one or more components chosen from group II. That is, that component A comprises only components chosen from groups I and II.

In a preferred embodiment of the present invention the components chosen from group I consist of a combination of subgroups:

i) one or more monofunctional, light-curable components having the formula (I), also referred to as reactive diluent (RD), comprising a reactive species Y that is susceptible to radical or cationic polymerization and a side group X, said one or more components of subgroup i) upon light-induced curing form a polymer backbone, said backbone preferably having a $T_g$ > 25 °C,

X-Y Formula (I)

and

ii) one or more mono- or multifunctional, light-curable components, which copolymerize(s) with the one or more components of subgroup i) via a curing mechanism, preferably having a molecular weight of > 500 g/mol, serving as a toughness-modifier (TNM), preferably forming a polymerized network with an elongation at break > 10% and a $T_g$ > 0 °C,

and optionally

iii) one or more light-curable crosslinking components, referred to as crosslinking agent (CA), which copolymerize(s) with the one or more components of subgroups i) and ii) via a curing mechanism.

In the context of the present application, the term "polymer backbone" defines a molecule that results from the polymerization of monofunctional components of subgroup i) to form a non-crosslinked polymer. The polymer backbone represents a sub-group of the first polymerized network of the present invention. Other monomers or oligomers may (co)polymerize with such a polymer backbone. Also, the polymerized network formed by the components of subgroup ii) represents a sub-network of the first polymerized network of the present invention. Also, in the context of the present application, the temperature $T_g$ of a specific component or a specific combination of components is the glass transition temperature derived typically via DMA from the maximum of the tan $\delta$ plot of the network that forms from this component alone or this combination of components alone without other networks, polymer backbones or sub-networks. The tan $\delta$ plot is recorded in accordance with the DMA method described herein.

In a preferred embodiment of the present invention, the amount of the one or more components of subgroup i) ranges from 5 wt% to 60 wt%, the amount of the one or more components of subgroup ii) ranges from 5 wt% to 95 wt% and the amount of the one or more components of subgroup iii) ranges from 5 wt% to 95 wt% based on the total weight of the components of subgroups i), ii) and iii).

In a preferred embodiment component A comprises a reactive diluent as subgroup i) represented by a component

of formula (I), wherein

- Y is a chemical species chosen from the groups of (meth)acrylate, (meth)acrylamide, vinyl ester, vinyl ether, vinyl amide, N-vinyl compounds, vinyl carbonate, vinyl carbamate, maleimide, itaconate, fumarate or styrene compounds, as well as derivatives thereof, which are optionally substituted with one or more of C1-C6 alkyl, C1-C6 alkoxy, C1-C6 thioether, halogen, -NO2, -SO3H, -CF3, -OH, -NH2, -SH, -CN, - trimethoxysilyl, or -triethoxysilyl, and
- X represents a linear, branched or cyclic, bicyclic or polycyclic C5-C40 aliphatic, heterocyclic or aromatic residue of one or more of the group consisting of methyl, ethyl, propyl, butyl, pentyl, hexyl, 2-ethylhexyl, octyl, decanyl, dodecanyl, acetic, propanoic, butanoic, pentanoic, undecanoic, dodecanoic, benzoic acid and corresponding esters, alkyl or aromatic esters, phenyl, benzyl, phenethyl, biphenyl, naphthyl, anthracenyl, pyrenyl, cyclopropyl, cyclobutyl, cyclopentyl, cyclohexyl, 4-isobutylcyclohexyl, cycloheptyl, cyclooctyl, adamantyl, isobornyl, salicyl, and cholesteryl, wherein one or more of these groups can be individually linked via an ester, amide, urea, urethane, carbonate, ether, or thioether group, which are optionally substituted with one or more of C1-C6 alkyl, C1-C6 alkoxy, C3-C7-cycloalkyl, C6-C10-aryl, C1-C6 thioether, halogen, -NO2, -SO3H, - CF3, -OH, -NH2, -SH, -CN, -trimethoxysilyl, or - triethoxysilyl.

Some preferred but non-limiting examples for reactive diluents as subgroup i) within component A include monofunctional (meth)acrylates, (meth)acrylamides, vinyl ester, N-vinyl compounds such as:
Isobornyl (meth)acrylate, cyclohexyl (meth)acrylate, trimethyl-cyclohexyl (meth)acrylate, glycerol formal (meth)acrylate, tricyclodecane methanol mono(meth)acrylate, 4-tert-butylcyclohexyl (meth)acrylate, benzyl (meth)acrylate, phenoxyethyl (meth)acrylate, cyclic trimethylolpropane formal (meth)acrylate, salicylate (meth)acrylates such as 2-(methacryloyloxy)benzoic acid cyclopentyl ester, 2-(methacryloyloxy)benzoic acid cyclohexyl ester, 2-(methacryloyloxy)benzoic acid-2-isopropyl-5-methylcyclohexyl ester, 3-(methacryloyloxy)benzoic acid-2-isopropyl-5-methylcyclohexyl ester, 4-(methacryloyloxy)benzoic acid-2-isopropyl-5-methylcyclohexyl ester, 2-(methacryloyloxy)benzoic acid-3,3,5-trimethylcyclohexyl ester, 2-(acryloyloxy)benzoic acid-3,3,5-trimethylcyclohexyl ester, 2-(methacryloyloxy)benzoic acid decahydronaphthalen-2-yl ester, 2-(methacryloyloxy)benzoic acid-1,3,3-trimethyl-2-bicyclo[2.2.1]heptanyl ester, 2-(methacryloyloxy)benzoic acid-1,7,7-trimethyl-2-bicyclo[2.2.1]heptanyl ester, 2-(methacryloyloxy)benzoic acid-bicyclo[2.2.1]heptan-2-yl methyl ester, 2-(methacryloyloxy)benzoic acid-2-cyclohexylethyl ester, 2-(methacryloyloxy)benzoic acid benzyl ester, 4-(methacryloyloxy)benzoic acid benzoate, 3-(methacryloyloxy)benzoic acid-4-isopropylbenzyl ester, 2-(acryloyloxy)benzoic acid benzyl ester, 2-(methacryloyloxy)benzoic acid phenethyl ester, 4-(methacryloyloxy)-3-methoxybenzoic acid-3-methoxybenzyl ester, 2-(methacryloyloxy)benzoic acid-1-phenylethyl ester, 4-((methacryloyloxy)methyl)benzoic acid cycloheptyl ester and 2-(methacryloyloxy)benzoic acid cyclohexyl methyl ester, cholesteryl (meth)acrylate, biphenyl (meth)acrylate, phenyl acrylamide, diacetone acrylamide, t-butyl acrylamide, N-acryloyl morpholine, N-vinyl pyrrolidone, N-vinyl caprolactam, N-vinyl formamide, vinyl cinnamate, vinyl methyl oxazolidinone, and 2-(allyloxymethyl)acrylic acid methyl ester.

In a preferred embodiment component A comprises as subgroup ii) a mono- or multifunctional, light-curable derivative as toughness modifier (TNM), which copolymerizes with other components of component A via a corresponding curing mechanism, having a number average molecular weight of > 500 g/mol, preferably > 1000 g/mol having one or more chemical species chosen from the group comprised of (meth)acrylate, (meth)acrylamide, vinyl ester, vinyl ether, vinyl amide, N-vinyl compounds, vinyl carbonate, vinyl carbamate, maleimide, itaconate, fumarate and styrene compounds, as well as derivatives and/or combinations thereof, optionally with a toughness modifier being at least one of (poly)ether, (poly)ester, (poly)carbonate, (poly)urethane, (poly)siloxane, (poly)amide, (poly)isoprene, modified epoxy functionalized oligomers, which are optionally substituted with one or more of C1-C6 alkyl, C1-C6 alkoxy, C3-C7-cycloalkyl, C6-C10-aryl, C1-C6 thioether, halogen, -NO2, -SO3H, -CF3, -OH, -NH2, -SH, -CN, -trimethoxysilyl, -triethoxysilyl, preferably forming a polymerized network with an elongation at break > 10%, preferably > 20%. Again, the elongation at break is measured by the pure polymerized network formed by these substances in absence of other polymers such as polymer backbones or other sub-networks.

Preferred TNMs as subgroup ii) within component A are multifunctional oligomers, prepolymers and/or polymers having an average reactive group functionality of > 1.3, preferably > 1.5, more preferred > 1.9 or an average reactive group functionality between 0.9 and 2.1, or between 0.9 and 3.1 or between 2.9 and 3.1 or between 1.9 and 2.1. The reactive groups in this context are functional groups that are susceptible to polymerization.

Some preferred examples for TNMs within component A are di- or multifunctional (meth)acrylates such as:
Ethoxylated bisphenol A di(meth)acrylates (e.g., Miramer 2200, Miramer 2301), aliphatic urethane di(meth)acrylates (e.g., Ebecryl 8811, Ebecryl 8809, Ebecryl 8409, Ebecryl 246, Miramer PU2100, Miramer SC2404, Miramer SC2565, Miramer PU2564, BR-571 MB, BR-7432GB, CN9001, CN965, CN981, CN8881 NS), polyether urethane (meth)acrylates (e.g., BR-541 MB, BR-582H15), hydrophobic urethane (meth)acrylates (e.g., BRC-443D already including 5-15% component A as reactive diluent (RD)), polyester urethane (meth)acrylates (e.g., BR-744 BT), polyester di(meth)acrylates (e.g., CN2608A, CN704, CN790, Ebecryl 4766), modified epoxy di(meth)acrylates (e.g., CN2003EU) and oligomeric

polycarbonate di(meth)acrylates.

In another preferred embodiment such TNMs may also be combined with and/or such TNMs may also comprise multiple urethane, ester and/or carbonate moieties.

Some preferred examples for crosslinking agents (CAs) within component A are comprised of at least one di- and/or multifunctional (meth)acrylate or a mixture of di- and/or multifunctional (meth)acrylates. These CAs can be composed from one or multiple polymerizable oligomers and hence oligomers polymerizable by light and are therefore specifically preferred as part of the light-curable component matrix. Multifunctional monomers making up CAs within component A are possibly polymerized via a radical mechanism. Such multifunctional monomers, by way of example, are tri-, tetra-, penta- and/or hexafunctional (meth)acrylates and/or hyperbranched and/or dendritic (meth)acrylates having even more functional sites. These are suitable for reasons of fast reaction rates and high crosslinking densities and improved heat resistance (e.g., higher $T_g$).

Some preferred compounds of CAs within component A of the inventive resin composition are multifunctional (meth)acrylates and/or a mixture of multifunctional (meth)acrylates, which bring about higher green strength of the 3D-printed part to support 3D-structuring of complex, thin-walled structures. Said crosslinking components are different from TNMs within component A as they either have a low molecular weight (< 500 g/mol) or higher reactive group functionality (> 2), which both result in higher crosslinking densities, thus overall higher green strength. The reactive groups in this context are functional groups that are susceptible to polymerization.

Such crosslinking agents (CA) within component A are preferably 1,4-butanedioldi(meth)acrylate, 1,6-hexanedioldi(meth)acrylate, 1,10-decanedioldi(meth)acrylate or 1,12-dodecanedioldi-(meth)acrylate, 1,6-bis-[2-(meth)-acryloyloxyethoxycarbonylamino]-2,2,4-trimethylhexane, pentaerythrittetra(meth)acrylate, di-, tri- or tetra-ethylenglycol-di(meth)acrylate and trimethylolpropantri(meth)acrylate.

Furthermore, preferred CAs within component A are composed of rigid groups such as aromatic or cycloaliphatic groups for reasons of low tendency toward polymerization shrinkage, high green strength, and high heat resistance of the cured resin. Some preferred CAs within component A are 2-(2-biphenyloxy)-ethyl(meth)acrylate, bisphenol-A-di(meth)acrylate (an addition product from (meth)acrylic acid and bisphenol-A-diglycidylether), ethoxy- or propoxylated bisphenol-A-di(meth)acrylate (e.g., 2-[4-(2-(meth)acryloyloxyethoxyethoxy)phenyl]-2-[4-(2-(meth)acryloyloxyethoxy)phenyl]-propane) or 2,2-bis[4-(2-(meth)acryloxypropoxy)phenyl]propane, tricyclodecanedimethanol di(meth)acrylate, isophorone urethane di(meth)acrylate, or tris(2-hydroxy ethyl)isocyanurate tri(meth)acrylate.

According to the present invention, the flame-retardant component B is a combination of i) at least one of a nitrogen donor and a polyphosphate and a polyphosphonate and ii) one or more inorganic phosphinate salts, wherein the weight ratio of i) to ii) is preferably between 1/9 and 9/1.

In a preferred embodiment component B is formulated in a way to obtain high flame resistance and processability by L-AMTs. This preferred combination is obtained when, in the component B, the amount of the at least one of a nitrogen donor and a polyphosphate and a polyphosphonate ranges from 20 wt% to 80 wt%, preferably from 20 wt% to 55 wt%, and the amount of the one or more inorganic phosphinate salts ranges from 20 wt% to 80 wt%, preferably from 45 wt% to 80 wt%, based on the total weight of the component B.

In a preferred embodiment the nitrogen donor of component B may be melamine, and/or melamine derivatives such as melem, melon, melamine cyanurate and/or ammonium derivatives and/or isocyanurate derivatives.

In a preferred embodiment the polyphosphate and/or polyphosphonate from component B decomposes under emission of non-combustible gases, which - by forming a blanketing gas layer - prevent the access of oxygen to the substrate. The residual acidic polyphosphates act as catalysts for the intumescent reaction by dehydration of carbon rich material and the forming of a carbonaceous foam by means of a blowing agent. Furthermore, these polyphosphoric compounds form highly protective layers onto the substrate.

In a preferred embodiment the nitrogen donor and/or polyphosphate and/or polyphosphonate from component B is an inorganic nitrogen donor and/or an inorganic polyphosphate and/or an inorganic polyphosphonate or a combination thereof. Some non-limiting, but preferred, examples of such inorganic nitrogen donors and/or inorganic polyphosphate and/or inorganic polyphosphonates are ammonium polyphosphate (e.g., mono- and/or diammonium phosphates) and melamine polyphosphate.

In a preferred embodiment component B further comprises at least one of an organic polyphosphate and an organic phosphonate, such as a phosphonate ester, more preferably being an aromatic polyphosphate and/or polyphosphonate such as Resorcinol-bis-(diphenyl phosphate) and/or an aromatic polyphosphate from (1-methylethylidene)di-4,1-phenylenetetraphenyl diphosphate and/or poly(m-phenylene methyl) phosphonate.

In a preferred embodiment the oligo- and/or polyphosphates and/or polyphosphonates from component B are liquids, which improve toughness of the final material, without having to sacrifice for (thermo)mechanical performance or causing a dramatic softening effect. Such preferred oligo- or polyphosphates are aromatic polyphosphates having a number average molecular weight of > 500 g/mol, preferably > 1000 g/mol and a phosphorus content > 4%, preferably > 8%.

In a preferred embodiment the inorganic phosphinate salt from component B acts as a flame retardant in the

condensed phase in contributing to charring of the polymer matrix and thus protecting the substrate against heat and oxygen attack. In parallel it acts in the gas phase by radical reactions removing from the combustion zone the high energy H- and OH-radicals, which determine flame propagation and heat release. Such inorganic phosphinate salts are preferably used as halogen-free flame-retardant additives for electrical and electronic applications.

In a preferred embodiment of the present invention, the one or more inorganic phosphinate salts in the component B comprise(s) at least one metal cation selected from the group comprised of aluminium, zinc, calcium, magnesium, iron, copper.

In a preferred embodiment of the present invention, the one or more inorganic phosphinate salts in the component B comprise(s) one, multiple or a combination of alkyl-, alkyl-aryl- and amid-containing substituents.

In a further preferred embodiment of the present invention, the inorganic phosphinate salt is one or a combination of an alkyl-substituted aluminum phosphinate such as aluminum dialkylphosphinates (e.g., aluminum methylethylphosphinate, aluminum diethylphosphinate, aluminum methylbutylphosphinate, aluminum methylcyclohexylphosphinate and/or aluminum diethylphosphinate) and/or an amide-containing phosphinate salt such as aluminum β-(N-phenylcarbamide)ethylmethylphosphinate, aluminum β-(N-cyclohexylcarbamide)ethylmethylphosphinate and/or aluminum β-(N-butylcarbamide)ethylmethyl phosphinate.

In a preferred embodiment of the present invention, the at least one of a nitrogen donor and a polyphosphate and a polyphosphonate and the one or more inorganic phosphinate salts are solids having a particle size distribution with a D50 value of 0.1 - 100 μm and a D95 value of max. 200 μm, preferably a D50 value of 0.5 - 40 μm and a D95 value of max. 100 μm, more preferably a D50 value of 0.5 - 20 μm and a D95 value of max. 50 μm. This brings upon improved processability of the inventive resin composition for L-AMTs and yields optimized print resolution and 3D-object surface characteristics. The average particle sizes of the fillers and respective particle size distributions from which the respective D50 and D95 values may be determined are typically derived via static light scattering methods using the Mie-theory according to DIN/ISO 13320.

In a preferred embodiment of the present invention, component B consists of

an amount of the at least one of an inorganic nitrogen donor and an inorganic polyphosphate and an inorganic polyphosphonate ranging from 5 to 80 wt%, preferably from 20 wt% to 70 wt%, more preferably from 20 wt% to 60 wt%, even more preferably from 20 wt% to 55 wt%, based on the total weight of the component B,
an amount of the at least one organic polyphosphate and an organic polyphosphonate ranging from 5 wt% to 95 wt%, preferably from 5 wt% to 50 wt%, more preferably from 10 wt% to 30 wt%, based on the content of the at least one of an inorganic nitrogen donor and a polyphosphate and a polyphosphonate,
and an amount of the one or more inorganic phosphinate salts ranging from 20 wt% to 80 wt%, preferably from 30 wt% to 80 wt%, more preferably from 40 wt% to 80 wt% and even more preferably from 45 wt% to 80 wt%, based on the total weight of the component B.

By way of example, preferred combinations of ranges for nitrogen donors and/or polyphosphates and/or polyphosphonates and inorganic phosphinate salts making up component B within the inventive resin composition can be derived from the following table or from the herein disclosed non-limiting examples:

| Constituent of Component B | Exemplary composition A | Exemplary composition B | Exemplary composition C |
|---|---|---|---|
| inorganic nitrogen donors and/or inorganic polyphosphates and/or inorganic polyphosphonates | - | 50 wt% (12.5 phr in formulation) | 40 wt% (10 phr in formulation) |
| organic polyphosphates and/or organic polyphosphonates | 50 wt% (12.5 phr in formulation) | - | 20 wt% (5 phr in formulation) |
| inorganic phosphinate salts | 50 wt% (12.5 phr in formulation) | 50 wt% (12.5 phr in formulation) | 40 wt% (10 phr in formulation) |
| phr ... parts per hundred resins | | | |

In a preferred embodiment of the present invention, the flame-retardant species of component B may be combined with a synergistic substance, that brings upon improved flame resistance, such as a halogen-free flame

retardant, such as a nitrogen donor (e.g., melamine, and/or melamine derivatives such as melem, melon, melamine cyanurate). This can be achieved via addition of said synergistic substance to the formulation and/or via coating of said substance onto the flame-retardant component B. Such a synergistic substance is preferably added in amounts of 0.1 wt% to 20 wt%, preferably 1 wt% to 10 wt%, based on the total weight of component B.

Preferably, the at least one of a nitrogen donor and a polyphosphate and a polyphosphonate and the one or more inorganic phosphinate salts in component B are functionalized and/or modified on their surface, e.g., functionalized with a polymerizable group such as (meth)acrylate, or silanized via radically polymerizable silanes such as 3-methacryloyloxypropyl tri-methoxy silane. For the surface modification of inorganic fillers functionalized, acidic components or ionic components may be used. With such modifications, phenomena like agglomeration, mixture stability, particle bonding to component A are controlled and/or influenced. This brings upon improved processability for the inventive resin composition and superior mechanical performance of the 3D-processed materials. Furthermore, such modifications preferably improve flame-resistance via coating or functionalization with flame-retardant substances.

In a preferred embodiment of the present invention, said component A additionally comprises a mono- or multifunctional, heat-curable component chosen from group II forming a second polymerized network with a $T_g$ > 100 °C, serving as a $T_g$-enhancer (TGE), wherein in component A, based on the total weight of the components of group I and group II, the amount of the one or more components of group II ranges from 1 to 50 wt%, preferably from 2 wt% to 40 wt%, more preferably from 3 wt% to 30 wt%, even more preferably from 5 wt% to 25 wt%, and the amount of the one or more components of group I ranges from 50 wt% to 99 wt%, preferably from 60 wt% to 98 wt%, more preferably from 70 wt% to 97 wt%, even more preferably from 75 wt% to 95 wt%.

In a preferred embodiment the one or more heat-curable components chosen from group II, serving as a $T_g$-enhancer (TGE), forming a second polymerized network with a $T_g$ > 100 °C, preferably > 150 °C, even more preferably > 200 °C has or have one or more chemical species chosen from the group comprised of allyl, vinyl, maleimide, citraconimide, benzoxazine, epoxy, phenol, cyanate ester and phthalonitrile, and oligomers thereof, polymers thereof, and isomers thereof and/or combinations thereof, preferably rendering the final formulation storage stable at ambient conditions with the second or further multiple curing steps being latent and selectively triggered simultaneously or subsequently to the first light-curing step. The respective crosslinked polymer networks could be formed via thermal curing reactions, which are polymerization methods known to the expert in the field.

Preferred components from group II are mono- and/or multifunctional, heat-curable components, which are responsible for forming a second polymerized network with a $T_g$ > 100 °C, preferably > 150 °C, more preferably > 180 °C, even more preferably > 200 °C or a $T_g$ from 80 °C to 120 °C, or 120 °C to 150 °C, or 150 °C to 180 °C, or 180 °C to 220 °C, or 220 °C to 250 °C, or 250 °C to 300 °C. Thus, said components provide for an improved heat resistance (e.g., measured by $T_g$ or heat deflection temperature (HDT), for instance according to ISO 75-1:2020) of the final photopolymer network while maintaining toughness (e.g., measured by elongation at break, for instance according to ISO 527). Again, the temperature $T_g$ is measured as the glass transition temperature of the network formed from the mono- and/or multifunctional, heat-curable components without the presence of other chemical species and measured via DMA as described herein and derived from the maximum value of the tan$\delta$ plot.

Preferably, the at least one photoinitiator is suitable for light excitation within a wavelength spectrum of 150 nm to 1000 nm, more preferably 200 nm to 550 nm, and is preferably present in an amount of 0.01 wt% to 10 wt%, preferably 0.1 wt% to 7 wt%, more preferably 0.2 wt% to 5 wt%, based on the weight of the component A. This means the photoinitiators can be activated with light and initiate polymerization of the light-curable components of the formulation.

Preferred components from group II are mono- and/or multifunctional, heat-curable components that are

i) comprising rigid substituents responsible for the formation of polymer backbones or polymer networks providing the required high $T_g$, such as aromatic and/or cycloaliphatic groups and/or heterocyclic groups and/or groups exhibiting strong intermolecular forces, further providing a low tendency toward polymerization shrinkage, such components preferably being oligomers and/or prepolymers with higher molecular weight (number average molecular weight > 500 g/mol), and/or

ii) of low molecular weight (number average molecular weight < 500 g/mol), which results in higher crosslinking densities, thus overall higher heat resistance, and/or

iii) of high reactive group functionality (> 2) with respect to reactive groups, which results in higher crosslinking densities, thus overall higher heat resistance.

Preferred components from group II within component A can be efficiently cured via a heat-curing step that is performed subsequently to the light-curing step for components A, wherein the heat-curing step is performed at a temperature that is higher than the initial processing temperature for the light-curing step, preferably at > 100 °C, more preferably > 120 °C, even more preferably > 140 °C and at a temperature where the formed material still exhibits sufficient thermal stability, preferably < 350 °C, more preferably < 300 °C, even more preferably < 200 °C.

Preferred components from group II within component A can be efficiently cured via a heat-curing step that is

performed subsequently to the light-curing step for components A, wherein the heat-curing step is performed by applying heat directly via active heating in an oven (e.g., electric, gas or solar oven) or indirectly via microwave irradiation, other light impulses (such as infrared light) or secondary exothermic reactions such as thermal polymerization and/or combinations thereof.

Some preferred examples for components from group II within component A are heat-curable components having one or more chemical species chosen from the group consisting of monomers and/or oligomers and/or prepolymers of maleimide and citraconimide derivatives according to formula (II),

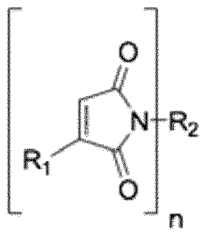

Formula (II)

as well as isomers thereof, in particular itaconimide, wherein

- n is an integer between 1 and 10
- $R_1$ represents H, $CH_3$ or $CH_2$,
- $R_2$ independently represents a linear, branched or cyclic $C_5$-$C_{40}$ aliphatic or aromatic residue of one or more of the group consisting of methyl, ethyl, propyl, butyl, pentyl, hexyl, 2-ethylhexyl, octyl, decanyl, dodecanyl, acetic, propanoic, butanoic, pentanoic, undecanoic, dodecanoic, benzoic acid and corresponding esters, alkyl or aromatic esters, cyclopropyl, cyclobutyl, cyclopentyl, cyclohexyl, 4-isobutylcyclohexyl, cycloheptyl, cyclooctyl, adamantyl, isobornyl, salicyl, cholesteryl, phenyl, benzyl, phenethyl, propenyl, biphenyl, naphthyl, anthracenyl, pyrenyl, bis(methylene)oxy, bis(ethylene)oxy, bis(phenyl)methane, bis(phenyl)ethane, bis(phenyl)propane, bis(phenyl)butane, bis(phenyl)ether, bis(phenyl)thioether, bis(phenyl)amino and bis(phenyl)sulfone, where one or more of these groups are optionally, individually linked via an ester, amide, urea, urethane, carbonate, ether, thioether group, which are optionally substituted with one or more $C_1$-$C_6$ alkyl, $C_1$-$C_6$ alkoxy, $C_1$-$C_6$ thioether, halogen, $-NO_2$, $-SO_3H$, $-CF_3$, -OH, $-NH_2$, -SH, -CN, -trimethoxysilyl, -triethoxysilyl or a polymerisable group from the substance classes of maleimide and citraconimide compounds and/or isomers thereof, in particular itaconimide.

Some other preferred examples for components from group II within component A are multifunctional allyl compounds comprising rigid substituents responsible for the formation of polymer backbones or polymer networks providing the required high $T_g$, such as aromatic and/or cycloaliphatic and/or heterocyclic groups and/or groups exhibiting strong intermolecular forces, such as urethane and/or urea and/or carbonate groups, further providing a low tendency toward polymerization shrinkage. Examples of such multifunctional allyl compounds are 1,3,5-triallyl-1,3,5-triazine-2,4,6(1H,3H,5H)-trione, 2,4,6-triallyloxy-1,3,5-triazine, triallyl borate, triallyl 1,3,5-benzenetricarboxylate, triallyl citrate, triallyl phosphate, tetraallyl pyromellitate, tetraallyloxyethane, diallyl propyl isocyanurate, diallyl isocyanurate, diallyl phthalate, 2,2-bis(4-allyloxy-3,5-dibromophenyl)propane, diallyl dicarbonate, diallyl carbonate, diallyl 1,4-cyclohexanedicarboxylate, 2,2-diallyl bisphenol A diacetate ether, diallyl terephthalate, diallyl isophthalate, diethyl diallylmalonate, 1,3-diallylurea, 1,3-diallyl-2-thiourea, 2,4-diamino-6-diallylamino-1,3,5-triazine, diallyl oxalate, diallyl malonate, diallyl tetrabromophthalate, 2,6-dially-meta-cresol, N,N-diallylaniline, diallyl cyanamide, N,N-diallylmelamine, 2,2'-diallylbisphenol A, N,N'-diallylpiperazine, 2,2-diallylpyrrolidine, diallyl-carbamic acid tert-butyl ester, diallyl ether bisphenol A, diallyl phenylphosphonate, 5,5'-diallyl-[1,1'-biphenyl]-2,2'-diol, cyclohexanone diallyl acetal, 4,4'-diallyl-1,1'-biphenyl, 2,2-diallyl-4,4-biphenol.

Some preferred examples for the one or more heat-curable components chosen from group II within component A are multifunctional epoxy compounds comprising rigid substituents responsible for the formation of polymer backbones or polymer networks providing the required high $T_g$, such as aromatic and/or cycloaliphatic and/or heterocyclic groups and/or groups exhibiting strong intermolecular forces, further providing a low tendency toward polymerization shrinkage and examples of such components are bisphenol A, bisphenol F and/or bisphenol S derivatives such as bisphenol A diglycidyl ether, bisphenol F diglycidyl ether, bisphenol S diglycidyl ether and/or diglycidyl 1,2-cyclohexanedicarboxylate, 4,4'-methylenebis(N,N-diglycidylaniline), trimethylolpropane triglycidyl ether, (3',4'-epoxycyclohexane)methyl-3,4-epoxycyclohexylcarboxylate, condensation products of 1-2-epoxy-4(2-oxiranyl)-cyclohexane and 2,2-bis(hydroxy methyl)1-butanol, bisphenol A novolac epoxy resins (e.g., SU-8 resin) and/or oligomers and/or prepolymers of these derivatives.

Components from group II within component A may also be compositions comprising two, three or multiple different components from group II as described above.

The relative amounts of components A and B within the inventive resin composition may be chosen such that

the amount of the one or more light-curable components chosen from group I in component A ranges from 60 wt% to 95 wt%, preferably from 65 wt% to 90 wt%, more preferably from 70 wt% to 85 wt% based on the total weight of the group I component(s) and component B,
the amount of the flame-retardant component B ranges from 5 to 40 wt%, preferably from 10 wt% to 35 wt%, more preferably from 15 wt% to 30 wt% based on the total weight of the group I component(s) and component B, and
the amount of the one or more heat-curable components chosen from group II within component A ranges from 1 to 50 wt%, preferably from 2 wt% to 40 wt%, more preferably from 3 wt% to 30 wt%, even more preferably from 5 wt% to 25 wt%, based on the total weight of component A.

By way of example, preferred combinations of ranges for components A and B within the inventive hybrid resin composition can be derived from the following table or from the herein disclosed non-limiting examples:

| Components | Exemplary composition 1 | Exemplary composition 2 | Exemplary composition 3 | Exemplary composition 4 |
|---|---|---|---|---|
| Group I components in A | 45-90 wt% | 45-80 wt% | 50-85 wt% | 55-80 wt% |
| B | 5-40 wt% | 10-35 wt% | 10-35 wt% | 15-30 wt% |
| Group II components in A | 5-15 wt% | 10-20 wt% | 5-15 wt% | 5-15 wt% |

In a preferred embodiment, the one or more heat-curable components chosen from group II within component A is/are responsible for forming a secondary polymer network upon the subsequently triggered heat-curing step, which improves network heterogeneity. In this way, the cured material constitutes

i) an interpenetrating polymer network; or
ii) a semi-interpenetrating polymer network; or
iii) a sequential interpenetrating polymer network; or
iv) a polymer blend

According to a preferred embodiment of the present invention, the inventive resin composition comprises at least one photoinitiator suitable for initiating polymerization upon light excitation, preferably light excitation within the wavelength spectrum of 150 nm to 1000 nm, more preferably between 200 nm to 550 nm, preferably in amounts of 0.01 wt% to 10 wt%, preferably 0.1 wt% to 7 wt%, more preferably 0.2 wt% to 5 wt% based on the total weight of component A. This means the photoinitiators can be activated with light and initiate polymerization of the light-curable components of the formulation.

The light-initiated polymerization (photopolymerization) is successful, when the applied light exposure is of a suitable wavelength for activating the photoinitiator and is of sufficient power. Aside from the light exposure being adequate for the photoinitiator, the overall formulation (e.g., optionally including light absorbing monomers, fillers or additives) may not interfere with the interaction of the emitted light and the photoinitiator. Light exposure applied herein includes any wavelength and power being able to initiate polymerization. Preferred wavelengths of light are 150 nm to 1000 nm, even more preferred between 200 nm to 550 nm. Any suitable NIR, UV or visible light source may be used, including but not limited to lasers or LED sources or broadband Hg-lamps. The light source may emit a broadband or narrowband light spectrum, or a combination thereof. The light source may emit continuous or pulsed light during single or repeated exposure periods, which may additionally be varied via time or intensity of exposure. A suitable and elevated process temperature will increase the reactivity of the system and thus enhance the light-induced structuring process. Adjusting the parameters and variables above will lead to an optimized protocol for carrying out the described photopolymerization reaction, yielding optimal 3D-processing via L-AMTs.

In a preferred embodiment, the light-induced curing step is carried out utilizing NIR (near infrared, from 780 to 2500 nm)- or UV/Vis (ultraviolet and visible, from 150 to 780 nm) light sources and corresponding optics, wherein the NIR-configuration is selected to enable 3D-fabrication via two photon photopolymerization and the UV/Vis-configuration is selected from the group consisting of laser/DLP, LED/DLP, laser/LCD, and LED/LCD.

Preferred photoinitiators are radical photoinitiators, such as Norrish type I photoinitiators alone or in combination with each other and may be selected from the group consisting of $\alpha$-hydroxyketones, phenylglyoxylates, benzyldimethylketals, $\alpha$-aminoketones, mono- or bisacylphosphines, -phosphineoxides, mono-, bis- or tetraacylsilanes, -germanes, -stannanes, metallocenes. Some preferred examples are 2-hydroxy-2-methylpropiophenone, 1-hydroxycyclohexyl phenyl ketone, methyl phenyl glyoxylates, 2-benzyl-2-(dimethylamino)-4'-morpholinobutyrophenone, [1-(4-phenylsulfanylbenzoyl)heptylideneamino]benzoate, [1-[9-ethyl-6-(2-methylbenzoyl)carbazol-3-yl]ethylideneamino] acetate, 2,4,6-trimethylbenzoyldiphenylphosphine oxide (TPO), ethyl-(2,4,6-trimethylbenzoyl)phenyl phosphinate (TPO-L), phenylbis(2,4,6-trimethylbenzoyl)phosphine oxide (BAPO), ethyl (3-benzoyl-2,4,6-trimethylbenzoyl) (phenyl) phosphinate, bis(4-methoxybenzoyl)diethylgermane (BMDG), and bis (cyclopentadienyl) bis [2,6-difluoro-3-(1-pyrryl) phenyl] titanium and/or polymeric type I photoinitiators such as Ominpol TP.

Preferred photoinitiators may also be Norrish type II photoinitiators. Some preferred examples are benzophenones (e.g., benzophenone, 4-methyl benzophenone, 4,4'-bis(diethylamino)benzophenone), benzoin, diketones (e.g., 9,10-phenanthrenequinone, 1-phenyl-propane-1,2-dione, diacetyl or 4,4'-dichlorobenzil and/or derivatives thereof), and thioxanthones (e.g., chloropropoxythioxanthones, isopropylxanthones or 2,4-diethyl-9H-thioxanthen-9-one). Such type II photoinitiators may be used in combination with coinitiators such as tertiary amines (e.g., aromatic tertiary amines such as N,N-dialkylaniline, -p-toluidine or -3,5-xylidine, p-N,N-dialkylamino-phenylethanol, -benzoic acid derivatives, -benzaldehyde or triethanolamine.

In further preferred embodiments, a combination of said type I and/or type II photoinitiators may be used.

In some preferred embodiments, the resin composition of the present invention comprises one or more of flame-retardant additives or smoke suppressing additives chosen from the group comprised of aluminum hydroxide, magnesium hydroxide, calcium hydroxide, antimony oxide, molybdenum oxide (e.g., $MoO_3$), tin oxide, borax and/or zinc borate, ammonium, calcium and/or zinc molybdates, red phosphorous, preferably stabilized and/or microencapsulated within a suitable solvent, expandable graphite, organic additives such as nitrogen donors and/or phosphorous containing substances, preferably triphenyl phosphine, 9,10-dihydro-9-oxa-10-phosphaphenanthren-10-oxide, and halogenated organic flame retardants such as halogenated phosphates, halogenated diphenylether, halogenated styrene, halogenated epoxides, halogenated (meth)acrylates and halogenated paraffins, preferably in amounts of 0.1 wt% to 10 wt%, more preferably 0.1 wt% to 5 wt%, based on the total weight of components A and B, with said one or more flame-retardant additive(s) preferably being functionalized with a polymerizable group such as (meth)acrylate.

Resin compositions of the inventive type can be processed in lithography-based 3D-printing applications at elevated temperatures, in which the inventive resin composition is heated and subsequently subjected to a layer-by-layer, light-induced build-up step, in which the light-curable component of the inventive resin composition is structured by light-curing to obtain 3D-objects via a lithography-based additive manufacturing method yielding materials with the aforementioned desirable combined flame resistance and (thermo)mechanical performance of improved temperature resistance (e.g., measured via $T_g$) and optimized toughness (e.g., measured via elongation at break).

In a preferred embodiment Hot Lithography is used as a processing method to enable the 3D-structuring of resins with a high content of component B, being solid fillers or oligomers or prepolymers. In this context, the inventive resin composition at room temperature, preferably, has a viscosity > 1 Pa·s, preferably > 5 Pa·s, measured according to DIN EN ISO 2884-1, DIN EN ISO 2884-2, or in accordance with the procedure described herein. The resulting materials offer improved flame resistance and (thermo)mechanical performance. This is substantiated by the herein disclosed (thermo)mechanical properties and high flame resistance for 3D-specimens produced via L-AMTs.

In some preferred embodiments the one or more heat-curable components chosen from group II do not cure unless subjected to heat, meaning temperatures higher than the processing temperature during the 3D-printing process, typically temperatures of > 50 °C, rendering the heat-curable system being latent and inherently forming a resin formulation that is storage stable at room temperature, meaning having a storage stability > 3 months or even > 6 months or even > 12 months (e.g., measured by an increase in viscosity < 10%, measured according to DIN EN ISO 2884-1, DIN EN ISO 2884-2, or in accordance with the procedure described herein) and the 3D-object is produced by the process of Hot Lithography.

In preferred embodiments, said heat-curing step may be achieved via active heating in an oven (e.g., electric, gas or solar oven) or indirectly via microwave irradiation, other light impulses (such as infra-red light) or secondary exothermic reactions such as thermal polymerization. Preferably, the heat-curable group II component A is stable at ambient conditions and at processing conditions of the light-curing step, thus a latent curing reaction needs to be induced.

In some preferred embodiments, at least one thermal initiator and/or catalyst may be used for the heat-curing of the one or more heat-curable components chosen from group II and/or its comonomers. Suitable catalysts may preferably be selected from the group consisting of tertiary amines (e.g., trialkylamines), in particular DABCO and/or DMAP and/or triethylamine and/or other aliphatic and aromatic secondary and/or tertiary amines, alkali salts of organic alcohols, phosphines, triphenyl phosphonate, imidazoles, in particular substituted imidazoles such as 2-methyl-1-vinyl imidazole, 2-phenylimidazole, 2-benzylimidazole and/or 2-ethyl-4-methyl imidazole, organic acids, and/or peroxides such as dibenzoyl peroxide, dilauroyl peroxide, dicumyl peroxide, tert-butylperbenzoate and/or di-(tert-butyl)-peroxide

and/or 1,1,2,2-tetraphenyl-1,2-ethanediol and/or dicyandiamide, preferably in amounts of 0.01 wt% to 10 wt%, preferably 0.1 wt% to 5 wt%, based on the weight of the one or more heat-curable components chosen from group II.

In further preferred embodiments the inventive resin composition comprises one or more initiators for radical polymerization, in particular thermal initiators, which are suitable for heat-curing of the one or more heat-curable components chosen from group II and/or post-curing of the one or more light-curable components chosen from group I. Some preferred examples are azo compounds, more preferably 2,2'azobis(isobutyronitrile) (AIBN) and/or azobis-(4-cyanovaleric acid) and/or peroxides, more preferably organic peroxides such as dibenzoyl peroxide, dilauroyl peroxide, dicumyl peroxide, tert-butylperbenzoate and/or di-(tert-butyl)-peroxide and/or 1,1,2,2-tetraphenyl-1,2-ethanediol, preferably in amounts of 0.01 wt% to 5 wt%, preferably 0.1 wt% to 4 wt%, more preferably 0.2 wt% to 3 wt%, based on the total weight of component A.

In some preferred embodiments, the resin formulation further comprises a comonomer and/or cooligomer and/or coprepolymer, which is able to copolymerize with the one or more heat-curable components chosen from group II as well as with derivatives thereof.

In some preferred embodiments, the inventive resin composition comprises at least one polymerization inhibitor, preferably an inhibitor selected from the group consisting of quinones such as hydroquinones and/or benzoquinones, phenothiazines, diethylhydroxylamine, 4-tert-butylcatechol, butylated hydroxytoluene, pyrogallol, TEMPO and/or 4-hydroxy-TEMPO, preferably in amounts of 0.001 wt% to 1 wt%, preferably 0.005 wt% to 0.5 wt%, more preferably 0.01 wt% to 0.1 wt% based on the total weight of component A.

In some preferred embodiments, the inventive resin composition comprises at least one light absorber such as a pigment or a dye, preferably a light absorber selected from the group consisting of inorganic particles such as titanium dioxide and/or carbon black and/or organic UV light absorbers such as benzophenone derivatives, benzotriazole derivatives, triazine derivatives, thioxanthones, hindered amine light-stabilizers such as Chimassorb, Tinuvin and/or Uvinul products and/or diethyl 2-(4-hydroxy-3-methoxybenzylidene)malonate, ethyl-2-cyano-3-(4- hydroxy-3-methoxy phenyl)acrylate, dimethyl 2-(4-hydroxybenzylidene)malonate and/or (E)-ethyl 2-(3-ethoxy-4-hydroxybenzylidene)-3-oxobutanoate, preferably in amounts of 0.001 wt% to 2 wt%, preferably 0.01 wt% to 1 wt%, more preferably 0.02 wt% to 0.5 wt% based on the total weight of component A.

The aforementioned synergistic flame-retardant additives, photoinitiators, thermal initiators, catalysts, inhibitors, light absorbers and other additives may be of polymeric nature and/or additionally functionalized with a polymerizable functional group, which can undergo polymerization with component A as it is in accordance with a preferred embodiment of the present invention.

In some preferred embodiments the inventive resin composition comprises additional toughness modifiers selected from the group consisting of thermoplastic resins. By way of example such thermoplastic resins could be polypropylene, polyethylene, polyamide, polyethylene oxide and/or polypropylene oxide, reactive rubbers, in particular butadiene-acrylonitrile copolymers and/or natural polymers such as cellulose and/or gelatin, such components are preferably terminated or functionalized with one or multiple reactive groups susceptible of radical or ionic polymerization (e.g., (meth)acrylate, (meth)acrylamide, vinyl esters, vinyl ether or styrene compounds, cyclic ethers such as epoxy compounds or oxetanes), and/or monomers comprising said reactive groups with flexible linkers, in particular long aliphatic chains and/or ethylene glycol spacers, preferably in amounts of 0.5 wt% to 30 wt%, preferably 2 wt% to 15 wt%, more preferably 5 wt% to 10 wt% based on the total weight of component A.

In some preferred embodiments, the resin composition of this invention comprises additional organic and/or inorganic fillers. Such mixtures are generally described as composites, preferred organic fillers may be but are not limited to core-shell particles, block copolymers, PTFE, high performance polymers, thermoplastics, in particular polyamides, polycarbonates, polystyrene, polyoxymethylene, poly(ether imides), polyethersulfones or polysulfones, rubbers, and the like. Preferred inorganic fillers may be metals, metal oxides and/or ceramics (e.g., $SiO_2$, $ZrO_2$, $TiO_2$, ZnO or mixtures thereof with an average particle size of 0.5 $\mu$m - 100 $\mu$m), silicates such as talc, clays, silica and/or mica, glass powders (in particular quartz, glass ceramics as preferred nano- or micro fillers with an average particle size of 0.1-100 $\mu$m), carbon black, graphene, graphite. The average particle size of the fillers may be determined via static light scattering methods using the Mie-theory according to DIN/ISO 13320 for the determination of average particle size and particle size distribution. In a second aspect, such organic or inorganic fillers may be spheres, platelets and/or fibers (e.g., nanofibers, whiskers, and/or mixtures thereof, spheres, fractures and/or defined three-dimensional, in particular graphite and/or two-dimensional structures, in particular monolayers of graphene).

Preferably, the fillers may be modified on their surface (e.g., silanized via radically polymerizable silanes such as 3-methacryloyloxypropyl trimethoxy silane). For the surface modification of inorganic fillers, such as $ZrO_2$ or $TiO_2$, functionalized, acidic phosphates (e.g., 10-methacryloyloxydecyldihydrogen phosphate) may be used. With such modifications, phenomena like agglomeration, mixture stability, particle bonding to the polymer matrix are controlled and/or influenced.

The resin composition of this invention may additionally comprise alone or in combination with each other the following components: stabilizers (such as UV-stabilizing agents or anti-aging agents), antioxidants, colorants (such as

dyes or pigments), antibacterial agents, antistatic agents, softeners or plasticizers or lubricants, wetting agents, matting agents, adhesion promoters, rheology modifiers, thixotropic agents, dispersants, optical brighteners, opacifying agents, anti-foam agents and/or UV-absorbers.

The inventive resin composition may be cured to form any object, including a coating, an adhesive, a sealant, an ink, or cured in a layer-by-layer or continuous fashion to form a 3D-object preferably via a 3D-printing process such as stereolithography and subsequently post-cured via a secondary or multiple further heat-curing steps.

The herein disclosed resin mixtures of components A, B and a photoinitiator may be mixed in various ratios and additional components as described above. Preferable ratios for mixing the formulations may be:

- At least one or more light-curable components chosen from group I of component A as a favorable combination of RD - subgroup i), TNM - subgroup ii) and CA - subgroup iii): 60 wt% to 95 wt%, preferably from 65 wt% to 90 wt%, more preferably from 70 wt% to 85 wt% based on the total weight of the group I component(s) in A and component B
- At least one combination of the at least one of a nitrogen donor and a polyphosphate and a polyphosphonate and the one or more inorganic phosphinate salts as component B (synergistic flame-retardant mixture): 5 wt% to 40 wt%, preferably from 10 wt% to 35 wt%, more preferably from 15 wt% to 30 wt%, based on the total weight of the group I component(s) in A and component B
- At least one photoinitiator: 0.01-10 wt%, preferably 0.1 wt% to 7 wt%, more preferably 0.2-5 wt% based on the weight of the group I component(s) in component A
- Optionally, one or more heat-curable components chosen from group II of component A (heat-curable $T_g$-enhancer): 0 wt% to 50 wt%, preferably from 2 wt% to 40 wt%, more preferably from 3 wt% to 30 wt%, even more preferably from 5 wt% to 25 wt% based on the total weight of the group I and group II component(s) in component A
- Optionally, a suitable thermal curing agent for the one or more heat-curable components chosen from group II: 0.01 wt% to 20 wt%, preferably 0.1 wt% to 15 wt%, more preferably 0.2 wt% to 10 wt% based on the weight of the one or more heat-curable components chosen from group II in component A.

The presence of the one or more light-curable components chosen from group I in component A provides for a cured material with reduced crosslinking density resulting in higher toughness (e.g., measured by elongation at break), yet maintained heat resistance due to a rigid polymer backbone originating from the respective reactive diluents, subgroup i).

The presence of the multifunctional TNM - subgroup ii) - within the one or more light-curable components chosen from group I within component A, having a molecular weight of > 500 g/mol, preferably > 1000 g/mol, is responsible for forming a first polymerized network with improved toughness (e.g., increased elongation at break).

The one or more light-curable components chosen from group I within component A, being reactive diluent, toughness modifiers and/or crosslinking agent, are responsible for the light-triggered structuring step and are selected to provide sufficient green strength and allow for 3D-structuring of the formulations, preferably via Hot Lithography using temperatures in the build-up step of 30 to 150 °C. The presence of the crosslinking agent CA - subgroup iii) - further improves the green strength and 3D-structuring of the formulations. The photopolymer formed after the light-curing step is characterized as a tough photopolymer preferably exhibiting a $T_g$ > 25 °C and an elongation at break > 3%.

The presence of the flame-retardant component B is responsible for the improved flame resistance of the resulting 3D-printed material. The combination of a nitrogen donor and polyphosphates and/or polyphosphonates with one or more inorganic phosphinate salts in synergistic mixing ratios brings upon materials with improved flame resistance (down to 1.5 mm UL 94 V0 and even further) at minimal required loading of flame-retardant component B (lower than 40 wt%). This enables the fabrication of flame-resistant 3D-objects with improved (thermo)mechanical performance (e.g., $T_g$ > 90 °C; elongation at break > 3%). Additionally, the implementation of liquid organic polyphosphates and/or polyphosphonates enables the fabrication of flame-resistant 3D-objects with improved toughness. Depending on the composition of component A, there are process-dependent favorable compositions of component B. Polyphosphates and/or polyphosphonates can increase the green strength of the fabricated 3D objects, which enables easier post-processing. Liquid, organic polyphosphates and/or polyphosphonates can be viscosity reducing, which can lead to better process control: e.g., lower peeling forces, reduced foaming. In addition to achieving a (synergistic) flame-retardant effect with the lowest possible use of component B, its constituents should further preferably be selected in such a way that optimization of the production process, improved green properties and easier post-processing are achieved.

The presence of the multifunctional one or more heat-curable components chosen from group II within component A is responsible for forming a second polymerized network with a $T_g$ > 100 °C and thus provides for an improved heat resistance (e.g., measured by $T_g$ or heat deflection temperature (HDT), for instance according to ISO 75-1:2020) of the final photopolymer network while maintaining toughness (e.g., measured by elongation at break, for instance via ISO 527-1:2019 and ISO 527-2:2019).

According to a further aspect, the invention relates to a method of manufacturing an object from the inventive resin composition, wherein the resin composition is subjected to a light-induced structuring step optionally followed by

a heat-induced curing step. In a preferred embodiment the light-induced structuring step is followed by a light-induced post-curing step. As will be apparent to one skilled in the art, the curing process via light may be an additive manufacturing process, more preferably a 3D-printing process with the respective UV and/or thermal post-processing steps to obtain the final product having the desired chemical, mechanical and thermal properties. The inventive resin formulations may thus be used as resin formulations for making 3D-objects via additive manufacturing. Resulting 3D-objects offer exceptional balance of flame resistance, while exhibiting high toughness. Possible applications for such additively manufactured 3D-objects from said materials may be jigs and fixtures, automotive parts (e.g., housings and interior facings, parts in contact with fuel such as connectors), electronic connectors, parts for printed circuit boards, packaging and cooling architectures for electronics, chip mounting, robotic hands, battery storage enclosures, and/or other application examples where there is a demand for high flame resistance, mechanical durability and thermal stability at temperatures > 50 °C.

According to a preferred embodiment of the method, the light-induced structuring step is carried out using light having a wavelength in the range of 150 nm to 2500 nm. Preferably, the light-induced structuring step is carried out utilizing an NIR - (from 780 to 2500 nm) or UV/Vis light source (from 150 to 780 nm) and corresponding optics, wherein the NIR-configuration is selected to enable 3D-fabrication via two photon photopolymerization, and the UV/Vis configuration is selected from the group consisting of laser/DLP, LED/DLP, laser/LCD, and LED/LCD.

Typically, formulations with a viscosity below 1 Pa·s at ambient conditions or slightly higher temperatures between room temperature and below 35 °C are required for conventional L-AMTs and temperatures above 35 °C are rarely reached nor suitable. For resin viscosities higher than 1 Pa·s at temperatures higher than 35 °C, L-AMTs for highly viscous resins at elevated temperatures (e.g., Hot Lithography) become the printing processes of choice.

In a preferred embodiment, the light-induced structuring step is carried out at elevated processing temperatures of the resin composition, preferably at a temperature between 25 °C and 150 °C, more preferably between 35 °C and 100 °C, even more preferably between 40 °C and 90 °C. This is done in order to provide processability for a high content of the components A and B with potentially high molecular weight and high softening or melting temperatures and to reduce the viscosity of the inventive resin composition during the structuring step.

In a preferred embodiment, a layer of the resin composition is formed on a carrier plate, e.g., by means of a recoater blade. To facilitate this, the inventive resin composition preferably has a viscosity at the processing temperature of 0.01 to 70 Pa·s, preferably of 0.1 to 30 Pa·s, the layer being formed preferably having a thickness of less than 2 mm, more preferably less than 1 mm, even more preferably less than 0.8 mm.

Preferably, the heat-induced curing step is performed at a temperature that is higher than the processing temperature of the light-induced structuring step, and preferably between 100 °C and 400 °C, more preferably at a temperature of 120°C - 400°C or at a temperature of 100°C - 300 °C.

Further, in accordance with a preferred embodiment of the present invention, the heat-induced curing step comprises heating the object in an oven and/or subjecting the object to electromagnetic radiation and/or inducing secondary exothermic reactions such as thermal polymerization in the object.

In a more general way, the light-induced structuring step preferably comprises building the object on a construction platform layer-by-layer to obtain a stack of structured layers, wherein each structured layer is obtained by the steps of:

- forming an unstructured layer of predetermined thickness of the resin composition, and
- selectively projecting light onto the unstructured layer according to a desired pattern, thereby curing the resin composition to obtain the structured layer.

The light-induced structuring step is preferably performed for building an object by 3D-printing, wherein layers of said object are formed one after the other and one on top of each other by each forming a material layer of predetermined thickness of the resin composition between a transparent or at least partially transparent carrier such as a plate, a carrier film or a bottom of a vat, and a mechanically adjustable construction platform, or the object at least partially formed on the construction platform and wherein the so defined material layer is cured in a position-selective manner, in particular by irradiation through the transparent or at least partially transparent carrier, to provide the desired shape of the layer.

According to a preferred embodiment, the light-induced structuring step is carried out by using a first radiation source, wherein the radiation of the first radiation source is applied to the resin composition through the transparent carrier plate, and heating of the layer of resin composition to be structured is carried out by using a second radiation source, wherein the carrier plate is essentially impermeable for the radiation of the second radiation source. In this way, the carrier plate is heated by the radiation of the second radiation source, said radiation essentially not entering into the layer of the resin composition, and resin composition thus indirectly heated via the carrier plate is structured by the radiation of the first radiation source. In particular, the one or more heat-curable components chosen from group II within component A is not thermally cured by said second radiation source.

In a preferred embodiment, a layer of the resin composition is formed on a carrier plate (e.g., by means of a recoater blade) and the layer is being cured via the first light-curing step, wherein the thickness of the formed layer is

greater than 10 μm, preferably greater than 25 μm, more preferably greater than 50 μm and even more preferably greater than 80 μm, and smaller than 1000 μm, preferably smaller than 800 μm, more preferably smaller than 500 μm and even more preferably smaller than 400 μm, and the curing thickness preferably comes down to > 1.1 times the layer height of the 3D-printing process.

In a preferred embodiment an object is produced from the inventive resin composition, wherein the light-induced structuring step is an additive manufacturing process and/or 3D-printig process, preferably stereolithography, digital light processing, material jetting or inkjet printing, more preferably based on the Hot Lithography technology.

After the light-induced curing step of the inventive resin has been performed, a heat-curing step may be performed to yield further cure. The heating step may be performed within a temperature range of 100-350 °C, preferably within a temperature range of 100-300 °C and may be divided into one or more individual curing steps with defined time intervals at respectively defined temperatures and defined heating rates (e.g., 10 K/min). Non-limiting examples for such heat-curing steps could be:

Method A → 10 h at 160 °C,
Method B → 0.5 h at 170 °C and 2 h at 150 °C,
Method C → 0.5 h at 200 °C and 10 h at 160 °C,
Method D → 2 h at 120 °C and 2 h at 150 °C.

In a preferred embodiment, said heat-induced curing step is performed subsequently to the light-structuring 3D-printing step or after an additional UV post-processing step, wherein the shaped 3D-objects are cured at a temperature higher than the initial processing temperature of the light-structuring step, preferably at > 100 °C, more preferably > 120 °C, even more preferably > 140 °C and at a temperature where the formed material still exhibits sufficient thermal stability, preferably < 350 °C, more preferably < 300 °C, even more preferably < 200°C.

In a preferred embodiment a part cleaning step is performed between the light-structuring 3D-printing step and the ensuing heat-induced curing step, wherein such a part cleaning step is performed in physical (e.g., via centrifuge, shaking, pressured air, vacuum) and/or chemical form (e.g., solvent or vapour cleaning using isopropyl alcohol and/or glycol ethers and/or aromatic solvents and/or alkanes).

In a preferred embodiment the heat-induced curing step is performed subsequently to the light-structuring 3D-printing step, wherein the shaped 3D-objects are cured at a temperature higher than the initial processing temperature of the light-structuring step and the heat is applied directly via active heating in an oven (e.g., electric, gas or solar oven) or indirectly via microwave irradiation, other light impulses (such as infra-red light) or secondary exothermic reactions such as thermal polymerization and/or combinations thereof.

In a preferred embodiment a cured material and/or object is formed, which is characterized in that it exhibits improved flame resistance with a UL 94 V-0 classification, preferably at a wall thickness of < 4 mm, more preferably < 2 mm, even more preferably < 1.5 mm.

The inventive material and/or object that results from subjecting the inventive resin composition to a light-induced structuring step, optionally followed by a heat-induced curing or post-curing step via light or heat, is preferably characterized in that the object exhibits the following material properties:

i) a tensile modulus of 1 MPa or more, a tensile strength of 1 MPa or more, an elongation at break of 100% or more, and a flammability rating of UL 94 V-0 < 3 mm; or
ii) a tensile modulus of 500 MPa or more, a tensile strength of 10 MPa or more, an elongation at break of 20% or more, and a flammability rating of UL 94 V-0 < 3 mm; or
iii) a tensile modulus of 1500 MPa or more, a tensile strength of 25 MPa or more, an elongation at break of 5% or more, a glass transition temperature of 70 °C or more and a temperature value at 1 GPa storage modulus of 30 °C or more and a flammability rating of UL 94 V-0 < 3 mm; or
iv) a tensile modulus of 2000 MPa or more, a tensile strength of 30 MPa or more, an elongation at break of 3% or more, a glass transition temperature of 90 °C or more and a temperature value at 1 GPa storage modulus of 45 °C or more and a flammability rating of UL 94 V-0 < 3 mm.

In a preferred embodiment, a cured material and/or object is formed from the inventive resin composition and has a thermal conductivity of > 1 W/mK, more preferably > 1.5 W/mK and even more preferably > 2 W/mK.

As used herein, the term "polymer" refers to a molecule composed of repeating structural units connected by covalent chemical bonds and characterized by a substantial number of repeating units (e.g., equal to or greater than 10 repeating units and often equal to or greater than 50 repeating units and often equal to or greater than 100 repeating units) and a high molecular weight (e.g., greater than or equal to 5000 Da, 10000 Da or 20000 Da). Polymers are commonly the polymerization product of one or more monomer precursors. The term "polymer" includes homopolymers, or polymers consisting essentially of a single repeating monomer subunit. The term "polymer" also includes copolymers

which are formed when two or more different types of monomers are linked in the same polymer. Copolymers may comprise two or more monomer subunits, and include random, block, alternating, segmented, grafted, tapered and other copolymers.

As used herein, an "oligomer" refers to a molecule composed of repeating structural units connected by covalent chemical bonds and characterized by a number of repeating units less than that of a polymer (e.g., equal to or less than 10 repeating units) and a lower molecular weight than polymers (e.g., less than 20,000 Da or 10,000 Da). Oligomers may be the polymerization product of one or more monomer precursors. In an embodiment, an oligomer or a monomer cannot be considered a polymer in its own right.

A "prepolymer" refers to a polymer or oligomer, the molecules of which are capable of entering, through reactive groups, into further polymerization.

Oligomers and polymer mixtures may additionally form crosslinks, thus create polymer networks.

Oligomers and polymer mixtures can be characterized and differentiated from other mixtures of oligomers and polymers by measurements of molecular weight and molecular weight distributions.

As used herein, the term "molecular weight" refers to the number average molecular weight as measured by gel permeation chromatography (GPC) or size exclusion chromatography (SEC) calibrated with polystyrene standards in a suitable solvent (typically tetrahydrofuran).

Examples

The embodiments disclosed in the present invention are described in more detail by reference to the following nonlimiting examples. These examples are presented for the purpose of illustration only and shall not be construed as limiting the scope of the invention as defined by the appended claims.

All chemicals used herein were purchased from commercial sources and used without further purification.

Curable compositions according to the present invention were prepared by mixing the respective compounds in a beaker with an anchor agitator from IKA or a speed mixer DAC 150 FVZ from Hauschild Engineering at a temperature of 25-60 °C. The resins were mixed until they became homogeneous formulations or stable suspensions. The resin formulations were further degassed in a vacuum oven Goldbrunn 450 until no air bubbles or (micro-)foam from mixing was detected within the formulation.

Rheological measurements for exemplary resin formulations were performed on an Anton Paar MCR 102 rheometer. For the evaluation of resin viscosities, the respective resin formulations were measured in rotation mode (PP-25, shear rate of 50 $s^{-1}$, temperature program 25-70 °C with a heating rate of 0.5 K/min, measurement gap of 1 mm). All references to viscosity throughout this specification and throughout the claims are determined in this way or could be determined according to DIN EN ISO 2884-1 or DIN EN ISO 2884-2.

(Thermo)mechanical test specimens and specimens for flammability testing of the final materials according to the present invention were fabricated from the exemplary resin compositions via Hot Lithography technology from the company Cubicure GmbH on a Caligma DLP printer (405 nm). All printer parts in contact with the formulations (i.e., material vat, recoating unit, recoating blade and building platform) were heated to a process temperature of 80 °C during the printing process. All 3D-objects fabricated on a Caligma DLP were printed with a light output intensity of ~ 50 mW $cm^{-2}$, a layer thickness of 100 $\mu$m and an irradiation time of ~ 0.8 s. The pixel size was set to ~ 50 $\mu$m on the upper surface of the material vat.

After each print job the 3D-printed specimens were mechanically detached from the building platform with a blade and excess resin was removed from the parts with a wipe and/or via solvent cleaning with isopropanol. A UV-post curing step was performed with all 3D-printed specimens in a Uvitron IntelliRay 600 at 100% intensity (~ 150 mW $cm^{-2}$, ~ 280-550 nm broadband) for 2 x 5 min and samples were flipped in between exposure cycles to ensure the light-curing step was completed. The thermal post-processing was conducted in a Heratherm OMH60 oven from Thermo Scientific with a temperature protocol according to listed methods (heating rate set to 10 K/min):

Method A $\rightarrow$ 30min @ 170 °C and passive cooling to 80 °C, for CE1-CE4 and E1-E4

A ProLine Z010 TH material tester from Zwick/Roell was used for tensile tests of the 3D-printed specimens. The test was performed according to DIN EN ISO 527 using 5A specimens. The tensile modulus was measured within 0.05-0.25% of elongation at a strain rate of 1 mm/min and then the measurement was continued with a strain rate of 10 mm/min.

DMA measurements to evaluate the storage modulus plots and glass transition temperature $T_g$ were performed on a Dynamic Mechanical Analyzer (DMA 8000 by Perkin Elmer) with a set temperature program (30 °C to 160 °C) and a heating rate of 2 K/min. Samples with a box geometry of 25 $\times$ 4 $\times$ 2 $mm^3$ were measured in 3-point-bending mode. The testing conditions were set to a frequency of 1 Hz, a strain of 50 $\mu$m and a preload force of 0 N. The glass transition temperature $T_g$ is derived from the maximum value of the loss factor plot (tan$\delta$).

Horizontal flammability tests were performed in accordance with the UL 94 HB standard, yet during the HB test the flame was positioned vertically and not in a 45° angle as stated by the UL 94 standard. The KBK 917 - Kleinbrennkasten

- from Netzsch Taurus instruments fueled by propane gas was used as a burning chamber. The specimens were stored in an HPP110eco oven from Memmert at 23 °C/50% rel. humidity for 96 hours prior to the flammability testing. The dimensions of the specimens were 90 mm in length, 12.7 mm in width and between 1 mm - 3 mm in thickness. The flame height of the burner was adjusted to be 20 mm and positioned to be centered beneath the cantilevered end of the specimen. The flaming duration during the HB testing was 10 seconds, after which the flame was removed from the edge of the specimen. The possible test outcomes are explained in the footnote of Table 2.

Vertical flammability tests were performed in accordance with the UL 94 standard. The KBK 917 - Kleinbrennkasten - from Netzsch Taurus instruments fueled by propane gas was used as a burning chamber. The specimens have been stored in an HPP110eco oven from Memmert at 23 °C/50% rel. humidity for 96 hours prior to the flammability testing. The dimensions of the specimens were 90 mm in length, 12.7 mm in width and between 1 mm - 3 mm in thickness.

The flame of the burner was adjusted to be 20 mm in height and positioned to be centered beneath the specimen to cover 10 mm of the specimens' lower edge during testing. After 10 seconds of exposure, the flame is removed. As soon as the flame ceases to form, the flame of the burner is again placed under the test piece for 10 seconds. The first and second burning times are noted. The possible test outcomes are explained in the footnote of Table 2.

Examples 1-4:

Examples 1-4 (E1-4) with only Examples E2 to E4 being examples of the inventive resin composition are composed of a light-curable component A in combination with flame retarding combinations of component B, to ensure synergistic flame-retardant effects; Comparative Examples 1-4 (CE1-4) make up respective light-curable resin and flame-retardant compositions comprising solely component A without a flame retardant B (for CE1) and compositions of components A with a singular component of the flame retardants (FR) of components B respectively (for CE2-4).

Table 1: Formulation compositions for comparative examples 1-4 (CE1-4) and examples 1-4 (E1-4)

| Components | CE1 (wt%) | CE2 (wt%) | CE3 (wt%) | CE4 (wt%) | E1 (wt%) | E2 (wt%) | E3 (wt%) | E4 (wt%) |
|---|---|---|---|---|---|---|---|---|
| Monofunctional methacrylate (isobornyl methacrylate, comparative component A as RD - group I / subgroup i)) | 30 | 22.5 | 22.5 | 22.5 | 22.5 | 22.5 | 22.5 | 22.5 |
| Multifunctional methacrylate (polyester methacrylate EBECRYL-4766, comparative component A as TNM - group I / subgroup ii)) | 45 | 33.75 | 33.75 | 33.75 | 33.75 | 33.75 | 33.75 | 33.75 |
| Multifunctional acrylate (THEICTA, comparative component A as CA - group I / subgroup iii)) | 25 | 18.75 | 18.75 | 18.75 | 18.75 | 18.75 | 18.75 | 18.75 |
| Organic phosphate ester (aromatic polyphosphate, component B as FR) | - | 25 | - | - | 12.5 | 12.5 | | 5 |
| Inorganic polyphosphate (ammonium polyphosphate, component B as FR) | - | - | 25 | - | 12.5 | - | 12.5 | 10 |
| Inorganic phosphinate (diethyl phosphinic acid aluminium salt, component B as FR) | - | - | - | 25 | - | 12.5 | 12.5 | 10 |

Preparation of resin formulations:

CE1: 30 g of the monofunctional, light-curable component A, being isobornyl methacrylate as reactive diluent RD, 45 g of the light-curable component A, being the polyester methacrylate EBECRYL-4766 as toughness modifier (TNM) and 25 g of the light-curable component A, being the tris(2-hydroxyethyl)isocyanurate triacrylate (THEICTA) as crosslinking agent (CA), were homogenized together with 3 g (3 phr) of the photoinitiator ethyl phenyl(2,4,6-trimethylbenzoyl)phosphinate (TPO-L) and 0.3 g (0.3 phr) of the thermal initiator dicumyl peroxide (DCP).

CE2: 22.5 g of the monofunctional, light-curable component A, being isobornyl methacrylate as RD, 33.75 g of the light-curable component A, being the polyester methacrylate EBECRYL-4766 as TNM, 18.75 g of the light-curable

component A, being the tris(2-hydroxyethyl)isocyanurate triacrylate (THEICTA) as CA and 25 g of the organic polyphosphate as component B, being the oligomeric aromatic polyphosphate from (1-methylethylidene)di-4,1-phenylenetetraphenyl diphosphate (CAS 5945-33-5 and CAS 181028-79-5) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

CE3: 22.5 g of the monofunctional, light-curable component A, being isobornyl methacrylate as RD, 33.75 g of the light-curable component A, being the polyester methacrylate EBECRYL-4766 as TNM, 18.75 g of the light-curable component A, being the tris(2-hydroxyethyl)isocyanurate triacrylate (THEICTA) as CA and 25 g of the inorganic polyphosphate as component B, being ammonium polyphosphate (CAS 68333-79-9) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

CE4: 22.5 g of the monofunctional, light-curable component A, being isobornyl methacrylate as RD, 33.75 g of the light-curable component A, being the polyester methacrylate EBECRYL-4766 as TNM, 18.75 g of the light-curable component A, being the tris(2-hydroxyethyl)isocyanurate triacrylate (THEICTA) as CA and 25 g of the inorganic phosphinate salt as component B, being diethyl phosphinic acid aluminium salt (CAS 225789-38-8) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

E1: 22.5 g of the monofunctional, light-curable component A, being isobornyl methacrylate as RD, 33.75 g of the light-curable component A, being the polyester methacrylate EBECRYL-4766 as TNM, 18.75 g of the light-curable component A, being the tris(2-hydroxyethyl)isocyanurate triacrylate (THEICTA) as CA and component B as a combination of 12.5 g of the organic polyphosphate, being the oligomeric aromatic polyphosphate from (1-methylethylidene)di-4,1-phenylenetetraphenyl diphosphate (CAS 5945-33-5 and CAS 181028-79-5) as FR, together with 12.5 g of the inorganic polyphosphate, being ammonium polyphosphate (CAS 68333-79-9) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

E2: 22.5 g of the monofunctional, light-curable component A, being isobornyl methacrylate as RD, 33.75 g of the light-curable component A, being the polyester methacrylate EBECRYL-4766 as TNM, 18.75 g of the light-curable component A, being the tris(2-hydroxyethyl)isocyanurate triacrylate (THEICTA) as CA and component B as a synergistic combination of 12.5 g of the organic polyphosphate, being the oligomeric aromatic polyphosphate from (1-methylethylidene)di-4,1-phenylenetetraphenyl diphosphate (CAS 5945-33-5 and CAS 181028-79-5) as FR, together with 12.5 g of the inorganic phosphinate salt, being diethyl phosphinic acid aluminium salt (CAS 225789-38-8) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

E3: 22.5 g of the monofunctional, light-curable component A, being isobornyl methacrylate as RD, 33.75 g of the light-curable component A, being the polyester methacrylate EBECRYL-4766 as TNM, 18.75 g of the light-curable component A, being the tris(2-hydroxyethyl)isocyanurate triacrylate (THEICTA) as CA and component B as a synergistic combination of 12.5 g of the inorganic polyphosphate, being ammonium polyphosphate (CAS 68333-79-9) as FR, together with 12.5 g of the inorganic phosphinate salt, being diethyl phosphinic acid aluminium salt (CAS 225789-38-8) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

E4: 22.5 g of the monofunctional, light-curable component A, being isobornyl methacrylate as RD, 33.75 g of the light-curable component A, being the polyester methacrylate EBECRYL-4766 as TNM, 18.75 g of the light-curable component A, being the tris(2-hydroxyethyl)isocyanurate triacrylate (THEICTA) as CA and component B as a synergistic combination of 5 g of the organic polyphosphate, being the oligomeric aromatic polyphosphate from (1-methylethylidene)di-4,1-phenylenetetraphenyl diphosphate (CAS 5945-33-5 and CAS 181028-79-5) as FR, together with 10 g of the inorganic polyphosphate, being ammonium polyphosphate (CAS 68333-79-9) as FR and 10 g of the inorganic phosphinate salt, being diethyl phosphinic acid aluminium salt (CAS 225789-38-8) as FR, were homogenized together with 2.25 g (3 phr) of the photoinitiator ethyl phenyl(2,4,6-trimethylbenzoyl)phosphinate (TPO-L) and 0.225 g (0.3 phr) of the thermal initiator dicumyl peroxide (DCP).

Table 2: Results for comparative examples 1-4 (CE1-4) and examples 1-4 (E1-4)

| Property | CE1 | CE2 | CE3 | CE4 | E1 | E2 | E3 | E4 |
|---|---|---|---|---|---|---|---|---|
| Viscosity of formulation (Pa·s) at 25 / 40 / 55 / 70 °C | 6.85<br>1.89<br>0.66<br>0.30 | 6.70<br>1.79<br>0.59<br>0.26 | 10.20<br>3.14<br>1.16<br>0.57 | 17.31<br>5.48<br>2.08<br>1.09 | 9.00<br>2.48<br>0.80<br>0.08 | 11.46<br>3.22<br>1.09<br>0.49 | 16.28<br>4.87<br>1.75<br>0.85 | 16.36<br>4.60<br>1.58<br>0.73 |

(continued)

| Property | CE1 | CE2 | CE3 | CE4 | E1 | E2 | E3 | E4 |
|---|---|---|---|---|---|---|---|---|
| Tensile modulus E (MPa) | 2400 (± 137) | 1040 (± 18) | 2580 (± 262) | 2680 (± 190) | 1800 (± 45) | 1910 (± 29) | 2930 (± 66) | 2450 (± 108) |
| Tensile strength σ (MPa) | 57.1 (± 1.5) | 29.7 (± 1.0) | 37.7 (± 2.4) | 32.7 (± 1.7) | 33.2 (± 0.4) | 32.2 (± 0.4) | 37.2 (± 1.4) | 34.5 (± 1.8) |
| Elongation at break ε (%) | 11.7 (± 3.7) | 22.3 (± 4.9) | 5.6 (± 2) | 4.1 (± 0.7) | 10.5 (± 2.0) | 8.0 (± 1.7) | 3.3 (± 0.3) | 4.6 (± 0.8) |
| $T_{1GPa}$ (°C) | 63 | 31 | 78 | 81 | 47 | 51 | 75 | 60 |
| $T_{0.5GPa}$ (°C) | 83 | 47 | 95 | 98 | 65 | 69 | 92 | 78 |
| $T_g$ (°C) | 115 | 83 | 117 | 118 | 94 | 97 | 112 | 100 |
| Flammability Vertical (3 mm) | X1 | X1 | X2 | X2 | X1 | X1 | X3 | X3 |
| Flammability Vertical (1.5 mm) | X1 | X1 | X1 | X1 | X1 | X1 | X3 | X1 |
| Flammability Horizontal | C | C | B | B | C | B | A | A |

$T_{1Gpa}$: temperature at which storage modulus G' reaches 1 GPa
$T_{0.5GPa}$: temperature at which storage modulus G' reaches 0.5 GPa
$T_g$: glass transition temperature recorded at maximum of tanδ
X1: specimens burn completely after first 10 seconds of flame contact.
X2: specimens burn completely after second 10 seconds of flame contact.
X3: specimens do not burn completely after first and second 10 seconds of flame contact - pass for the test
A: Flame does not reach the first mark (25 mm) within 10 seconds
B: Flame does not reach the first mark (25 mm) within 1 minute
C: Flame does not reach the second mark (100 mm) within 1 minute
D: Flame reaches the second mark within one minute; failed test

Results (Flammability Vertical):

CE1 (3 mm/1.5 mm/1 mm) burns completely after first 10 seconds of flame contact. The flame steadily spreads to the top of the specimen.

CE2 (3 mm/1.5 mm/1 mm) burns completely after first 10 seconds of flame contact. The flame spreads slower than CE1 and flickers, thus a positive effect of the flame-retardant additive can be observed.

CE3 (3 mm) does not burn after first 10 seconds of flame contact but burns completely after the second 10 seconds of flame contact, thus a positive effect of the flame-retardant additive can be observed.

CE3 (1.5 mm/1 mm) burns completely after the first 10 seconds of flame contact.

CE4 (3 mm) burns in a very small flame for 20 seconds after the first 10 seconds of flame contact but burns completely after the second 10 seconds of flame contact. During the second burning phase a strong smoke formation is visible, yet a positive effect of the flame-retardant additive can be observed.

CE4 (1.5 mm/1 mm) burns completely after the first 10 seconds of flame contact.

E1 (3 mm/1.5 mm/1 mm) burns completely after the first 10 seconds of flame contact.

E2 (3 mm/1.5 mm/1 mm) burns completely after the first 10 seconds of flame contact.

E3 (3 mm) does not burn after the first flame contact but burns for 9 seconds after the second flame contact - PASS (X3) .

E3 (1.5 mm) does not burn after the first flame contact but burns 7 seconds after the second flame contact - PASS (X3). E3 (1 mm) does not burn after the first flame contact but burns 12 seconds after the second flame contact. - PASS (X3)

E4 (3 mm) does not burn after the first flame contact but burns 14 seconds after the second flame contact - PASS (X3) .

E4 (1.5 mm/1 mm) burns completely after the first 10 seconds of flame contact.

Results (Flammability Horizontal):

CE1 (1.5 mm) The flame does not reach the second mark on the specimen (100 mm) within 1 minute.
CE2 (1.5 mm) The flame does not reach the second mark on the specimen (100 mm) within 1 minute.
CE3 (1.5 mm) The flame does not reach the first mark on the specimen (25 mm) within 1 minute.
CE4 (1.5 mm) The flame does not reach the first mark on the specimen (25 mm) within 1 minute.
E1 (1.5 mm) The flame does not reach the second mark on the specimen (100 mm) within 1 minute.
E2 (1.5 mm) The flame does not reach the first mark on the specimen (25 mm) within 1 minute.
E3 (1.5 mm) The flame does not reach the first mark on the specimen (25 mm) within 10 seconds.
E4 (1.5 mm) The flame does not reach the first mark on the specimen (25 mm) within 10 seconds.

Discussion:

All tested formulations exhibit a viscosity in the range of 0.1-20 Pa·s at processing temperature, which provides a suitable range for the 3D-fabrication of these formulations via Hot Lithography (see Fig. 1).
The two materials standing out in the flammability tests are 3D-printed from the formulations E3 and E4. Both of those formulations are containing a promising and effective combination of the flame retarding components and display a synergistic combination of flame-retardant additives according to components B in the disclosure. The photopolymer from E3 is showing the highest E-modulus (2960 MPa) and $T_g$ (> 110 °C) among the inventive materials as well as the lowest elongation at break (~ 3.3%) while being able to pass the vertical flammability tests down to 1 mm of specimen thickness. However, the material E4 provides the most promising combination of both (thermo)mechanical and flame retarding material characteristics. Passing the vertical flammability test (3 mm) in combination with a significant increase of the elongation at break (~ 5 %) and still high $T_g$ (~ 100 °C) gives this material solution a clear advantage for specific applications over the other material combinations tested.
This effect of enhanced elongation was also clearly indicated when comparing the formulations CE2 to CE1 seen in Fig. 2. With the downside of dropping the values of modulus and strength significantly, the elongation at break could be enhanced from 11,7% to 22,3% when comparing CE1 to CE2. The formulations CE3 and CE4 showed an opposite effect by decreasing the elongation and enhancing the strength and modulus values compared to formulation CE1, which can be attributed to the positive effect of solid flame-retardant additives being the inorganic phosphinate salt - diethyl phosphinic acid aluminium salt - and the inorganic polyphosphate - ammonium polyphosphate.
As shown in Fig. 1 there is a decrease in viscosity over the temperature from E4 compared to E3 which further improves the processability of the inventive material. It is clearly indicated by CE3 and CE4 that an increase in solid flame retarding components shows a significant increase of the viscosity at a given temperature. Comparing CE2 to CE1 it was shown that a decrease in viscosity could be generated by adding a liquid component B to the matrix. In Fig. 3 a clear tanδ shift can be detected from CE1 to CE2 indicating the influence of the component B being a liquid organic phosphate ester. The tanδ shift to higher temperatures due to solid flame retardants as component B is not as strong but also clearly detectable.
The storage modulus seen in Fig. 4 also shows the softening effect of a liquid organic phosphate ester as component B and confirms the strengthening effect of solid flame retardants.

## BRIEF DESCRIPTION OF THE FIGURES

Fig. 1 shows the viscosity-temperature behaviour for comparative examples CE1-CE4 and examples E1-E4,
Fig. 2 shows the stress-strain behaviour for comparative examples CE1-CE4 and examples E1-E4,
Fig. 3 shows the thermo-mechanical behaviour (loss factor tanδ plot over temperature) for comparative examples CE1-CE4 and examples E1-E4,
Fig. 4 shows the thermo-mechanical behaviour (storage modulus G' plot over temperature) for comparative examples CE1-CE4 and examples E1-E4.

## Claims

1. Resin composition for the 3D-printing of objects with high flame resistance, comprising

a) a curable component A comprising one or more light-curable components chosen from group I consisting of (meth)acrylates, (meth)acrylamides, vinyl esters, vinyl ethers, vinyl amides, N-vinyl compounds, vinyl carbonates, vinyl carbamates, maleimides, itaconates, fumarates, styrene compounds, cyclic ethers such as epoxy compounds or oxetanes, benzoxazines, oxazolines, and cyanoacrylates, said one or more light-curable components chosen from group I forming a first polymerized network;
b) a flame-retardant component B being a combination of i) at least one of a nitrogen donor and a polyphosphate and a polyphosphonate and ii) one or more inorganic phosphinate salts, wherein the weight ratio of i) to ii) is preferably between 1/9 and 9/1; and
c) at least one photoinitiator suitable for polymerization upon light excitation,

wherein, based on the total combined weight of components A and B, the amount of the curable component A ranges from 60 wt% to 95 wt%, preferably from 65 wt% to 90 wt%, more preferably from 70 wt% to 85 wt%, the amount of the flame-retardant component B, based on the total combined weight of components A and B, ranges from 5 wt% to 40 wt%, preferably from 10 wt% to 35 wt%, more preferably from 15 wt% to 30 wt%, and, based on the weight of component A alone, the amount of the photoinitiator ranges from 0.01 wt% to 10 wt%.

**2.** Resin composition according to claim 1, wherein component A further comprises one or more heat-curable components chosen from group II consisting of mono- or multifunctional components, forming a second polymerized network with a $T_g$ > 100 °C, serving as a $T_g$-enhancer, wherein in component A, based on the total weight of the components of group I and group II, the amount of the one or more components of group II ranges from 1 to 50 wt%, preferably from 2 wt% to 40 wt%, more preferably from 3 wt% to 30 wt%, even more preferably from 5 wt% to 25 wt%, and the amount of the one or more components of group I ranges from 50 wt% to 99 wt%.

**3.** Resin composition according to claim 1 or 2, wherein the component A consists of the one or more components chosen from group I and optionally the one or more components chosen from group II.

**4.** Resin composition according to claim 1, 2 or 3, wherein the components chosen from group I consist of a combination of subgroups:

i) one or more monofunctional, light-curable components having the formula (I), comprising a reactive species Y that is susceptible to radical or cationic polymerization and a side group X, said one or more components of subgroup i) upon light-induced curing form a polymer backbone, said backbone preferably having a $T_g$ > 25 °C,

X-Y Formula (I)

and
ii) one or more mono- or multifunctional, light-curable components, which copolymerize(s) with the one or more components of subgroup i) via a curing mechanism, preferably having a molecular weight of > 500 g/mol, serving as a toughness-modifier, preferably forming a polymerized network with an elongation at break > 10% and a $T_g$ > 0 °C,
and optionally
iii) one or more light-curable crosslinking components, referred to as crosslinking agent (CA), which copolymerize(s) with the one or more components of subgroups i) and ii) via a curing mechanism.

**5.** Resin composition according to claim 4, wherein the amount of the one or more components of subgroup i) ranges from 5 wt% to 60 wt%, the amount of the one or more components of subgroup ii) ranges from 5 wt% to 95 wt% and the amount of the one or more components of subgroup iii) ranges from 5 wt% to 95 wt% based on the total weight of the components of subgroups i), ii) and iii).

**6.** Resin composition according to any one of claims 1 to 5, wherein in component B, the amount of the at least one of a nitrogen donor and a polyphosphate and a polyphosphonate ranges from 20 wt% to 80 wt%, preferably from 20 wt% to 55 wt%, and the amount of the one or more inorganic phosphinate salts ranges from 20 wt% to 80 wt%, preferably from 45 wt% to 80 wt%, based on the total weight of the component B.

**7.** Resin composition according to any one of claims 1 to 6, wherein in component B the at least one of a nitrogen donor and a polyphosphate and a polyphosphonate comprises or consist of at least one of an inorganic nitrogen donor and an inorganic polyphosphate and an inorganic polyphosphonate, preferably chosen from the group consisting of ammonium polyphosphates, in particular mono- and/or diammonium phosphates, and melamine polyphosphates.

8. Resin composition according to claim 7, wherein in component B the at least one of a nitrogen donor and a polyphosphate and a polyphosphonate further comprises at least one of an organic polyphosphate and an organic phosphonate, such as a phosphonate ester.

9. Resin composition according to any one of claims 1 to 8, wherein the one or more inorganic phosphinate salts in the component B comprise(s) at least one metal cation selected from the group comprised of aluminium, zinc, calcium, magnesium, iron, copper.

10. Resin composition according to any one of claims 1 to 9, wherein the one or more inorganic phosphinate salts in the component B comprise(s) one, multiple or a combination of alkyl-, alkyl-aryl- and amid-containing substituents.

11. Resin composition according to any one of claims 1 to 10, wherein in component B, the at least one of a nitrogen donor and a polyphosphate and a polyphosphonate and the one or more inorganic phosphinate salts are solids having a particle size distribution with a D50 value of 0.1 - 100 μm and a D95 value of max. 200 μm, preferably a D50 value of 0.5 - 40 μm and a D95 value of max. 100 μm, more preferably a D50 value of 0.5 - 20 μm and a D95 value of max. 50 μm.

12. Resin composition according to any one of claims 8 to 11, wherein component B consists of

an amount of the at least one of an inorganic nitrogen donor and an inorganic polyphosphate and an inorganic polyphosphonate ranging from 5 to 80 wt%, preferably from 20 wt% to 70 wt%, more preferably from 20 wt% to 60 wt%, even more preferably from 20 wt% to 55 wt%, based on the total weight of the component B,
an amount of the at least one of an organic polyphosphate and an organic polyphosphonate ranging from 5 wt% to 95 wt%, preferably from 5 wt% to 50 wt%, more preferably from 10 wt% to 30 wt%, based on the content of the at least one of a nitrogen donor and a polyphosphate and a polyphosphonate,
and an amount of the one or more inorganic phosphinate salts ranging from 20 wt% to 80 wt%, preferably from 30 wt% to 80 wt%, more preferably from 40 wt% to 80 wt% and even more preferably from 45 wt% to 80 wt%, based on the total weight of the component B.

13. Resin composition according to any one of claims 1 to 12, wherein the at least one of a nitrogen donor and a polyphosphate and a polyphosphonate and the one or more inorganic phosphinate salts in component B are functionalized and/or modified on their surface, e.g., functionalized with a polymerizable group such as (meth)acrylate, or silanized via radically polymerizable silanes such as 3-methacryloyloxypropyl tri-methoxy silane.

14. Resin composition according to any one of claims 2 to 13, wherein the one or more heat-curable components chosen from group II has or have one or more chemical species chosen from the group comprised of allyl, vinyl, maleimide, citraconimide, benzoxazine, epoxy, phenol, cyanate ester and phthalonitrile, and oligomers thereof, polymers thereof, and isomers thereof.

15. Resin composition according to any one of claims 1 to 14, wherein the at least one photoinitiator is suitable for light excitation within a wavelength spectrum of 150 nm to 1000 nm, more preferably 200 nm to 550 nm, and is preferably present in an amount of 0.01 wt% to 10 wt%, preferably 0.1 wt% to 7 wt%, more preferably 0.2 wt% to 5 wt%, based on the weight of the component A.

16. Resin composition according to any one of claims 1 to 15, wherein the resin composition comprises one or more of flame-retardant additives or smoke suppressing additives chosen from the group comprised of aluminum hydroxide, magnesium hydroxide, calcium hydroxide, antimony oxide, molybdenum oxide (e.g., $MoO_3$), tin oxide, borax and/or zinc borate, ammonium, calcium and/or zinc molybdates, red phosphorous, preferably stabilized and/or microencapsulated within a suitable solvent, expandable graphite, and halogenated organic flame retardants such as halogenated phosphates, halogenated diphenylether, halogenated styrene, halogenated epoxides, halogenated (meth)acrylates and halogenated paraffins, preferably in amounts of 0.1 wt% to 10 wt%, more preferably 0.1 wt% to 5 wt%, based on the total weight of the resin composition, with said one or more flame-retardant additive(s) preferably being functionalized with a polymerizable group such as (meth)acrylate.

17. Resin composition according to any one of claims 1 to 16, wherein the resin composition at room temperature has a viscosity > 1 Pa·s, preferably > 5 Pa·s.

**18.** Resin composition according to any one of claims 1 to 17, wherein the resin composition comprises one or more initiators for radical polymerization, in particular thermal initiators.

**19.** A method of manufacturing an object by 3D-printing, wherein a resin composition according to any one of claims 1 to 18 is subjected to a light-induced structuring step, optionally post-cured via a secondary light exposure, optionally followed by a heat-induced curing step.

**20.** Method according to claim 19, wherein the light-induced structuring step is carried out using light having a wavelength in the range of 150 nm to 2500 nm.

**21.** Method according to claim 19 or 20, wherein the light-induced structuring step is carried out at a processing temperature of the resin composition of between 25 °C and 150 °C, more preferably between 35 °C and 100 °C, even more preferably between 40 °C and 90 °C.

**22.** Method according to claim 21, wherein the resin composition has a viscosity at the processing temperature of 0.01 to 70 Pa·s, preferably of 0.1 to 30 Pa·s.

**23.** Method according to claim 21 or 22, wherein the heat-induced curing step is performed at a temperature that is higher than the processing temperature of the light-induced structuring step, and preferably between 100 °C and 400 °C, more preferably at a temperature of 120°C - 400°C or at a temperature of 100°C - 300 °C.

**24.** Method according to any one of claims 19 to 23,
wherein the heat-induced curing step comprises heating the object in an oven and/or subjecting the object to electromagnetic radiation and/or inducing secondary exothermic reactions such as thermal polymerization in the object.

**25.** Method according to any one of claims 19 to 24, wherein the light-induced structuring step comprises building the object on a construction platform layer-by-layer to obtain a stack of structured layers, wherein each structured layer is obtained by the steps of:

- forming an unstructured layer of predetermined thickness of the resin composition, and
- selectively projecting light onto the unstructured layer according to a desired pattern, thereby curing the resin composition to obtain the structured layer.

**26.** An object manufactured from a resin composition according to any one of claims 1 to 18 by a method according to any one of claims 19 to 25.

**27.** An object according to claim 26, having a flame resistance corresponding to the V-0 classification of the UL 94 standard, preferably at a wall thickness of < 4 mm, more preferably < 2 mm, even more preferably < 1.5 mm.

**28.** An object according to claim 26 or 27, wherein it exhibits

i) a tensile modulus of 1 MPa or more, a tensile strength of 1 MPa or more, an elongation at break of 100% or more, and a flammability rating of UL 94 V-0 < 3 mm; or
ii) a tensile modulus of 500 MPa or more, a tensile strength of 10 MPa or more, an elongation at break of 20% or more, and a flammability rating of UL 94 V-0 < 3 mm; or
iii) a tensile modulus of 1500 MPa or more, a tensile strength of 25 MPa or more, an elongation at break of 5% or more, a glass transition temperature of 70 °C or more and a temperature value at 1 GPa storage modulus of 30 °C or more and a flammability rating of UL 94 V-0 < 3 mm; or
iv) a tensile modulus of 2000 MPa or more, a tensile strength of 30 MPa or more, an elongation at break of 3% or more, a glass transition temperature of 90 °C or more and a temperature value at 1 GPa storage modulus of 45 °C or more and a flammability rating of UL 94 V-0 < 3 mm.

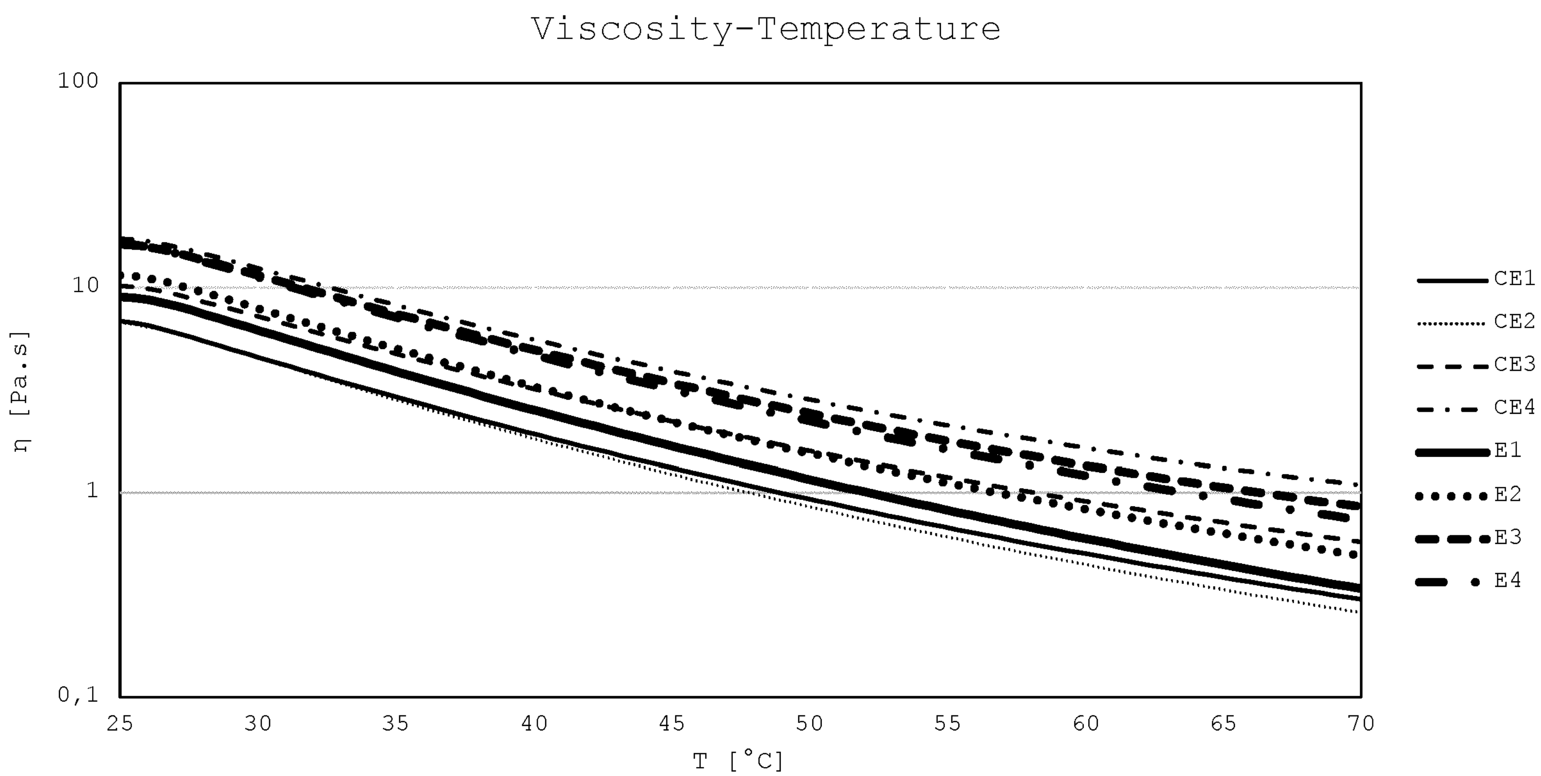


Viscosity-temperature behaviour for comparative examples CE1-CE4 and examples E1-E4.

**Fig. 1**

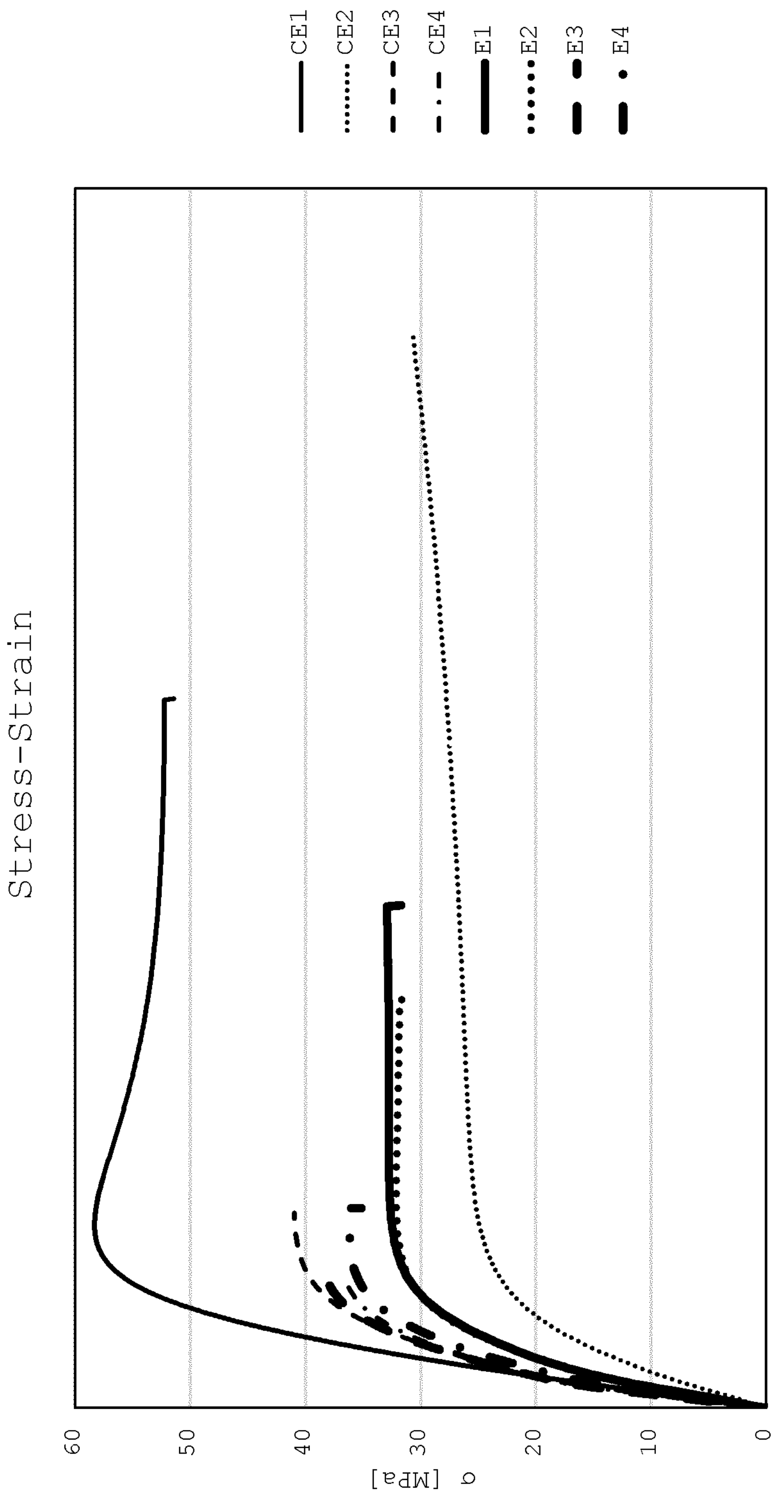


Stress-strain behaviour for comparative examples CE1-CE4 and examples E1-E4.

**Fig. 2**

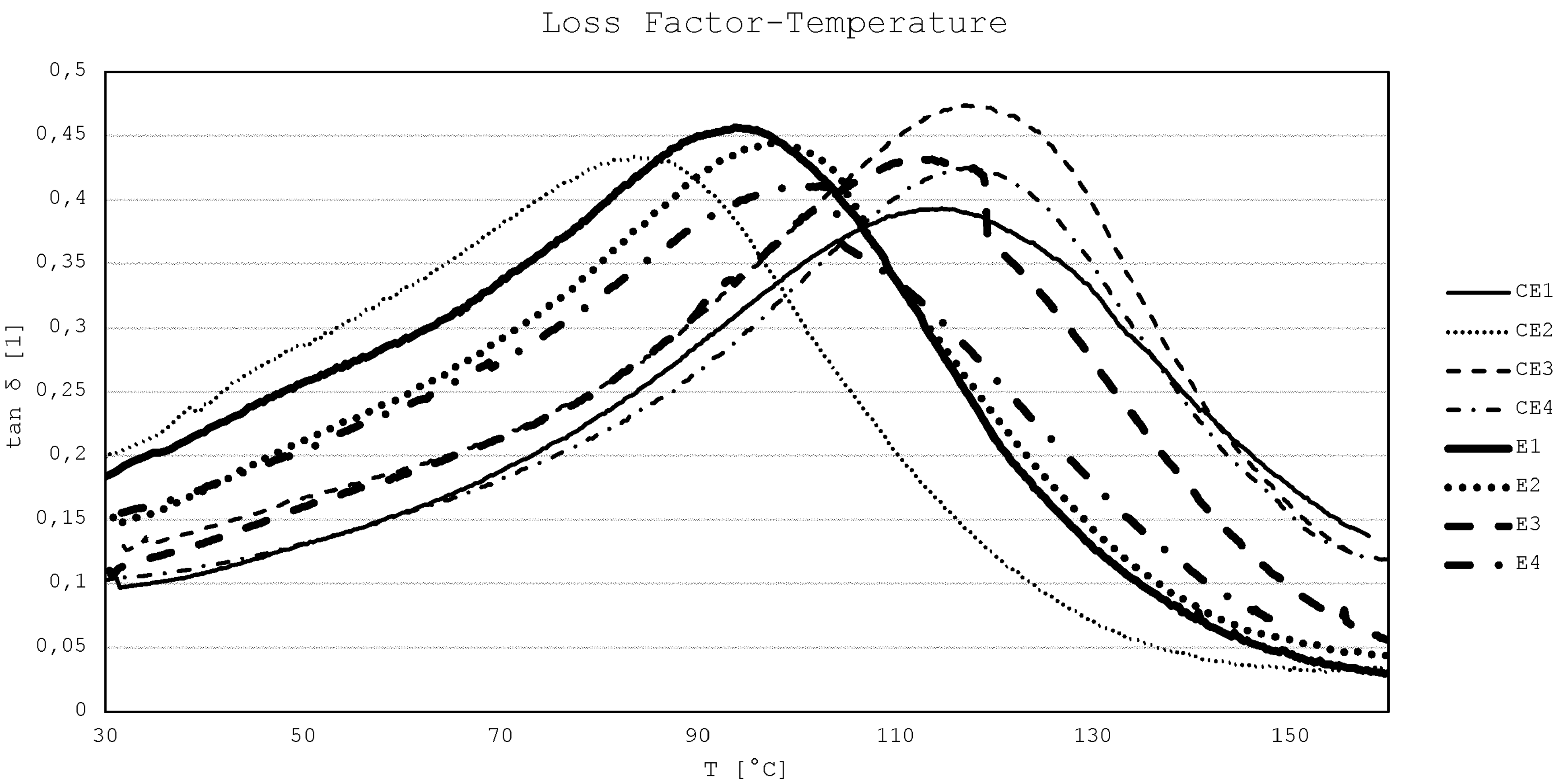


Thermo-mechanical behaviour for comparative examples CE1-CE4 and examples E1-E4.

**Fig. 3**

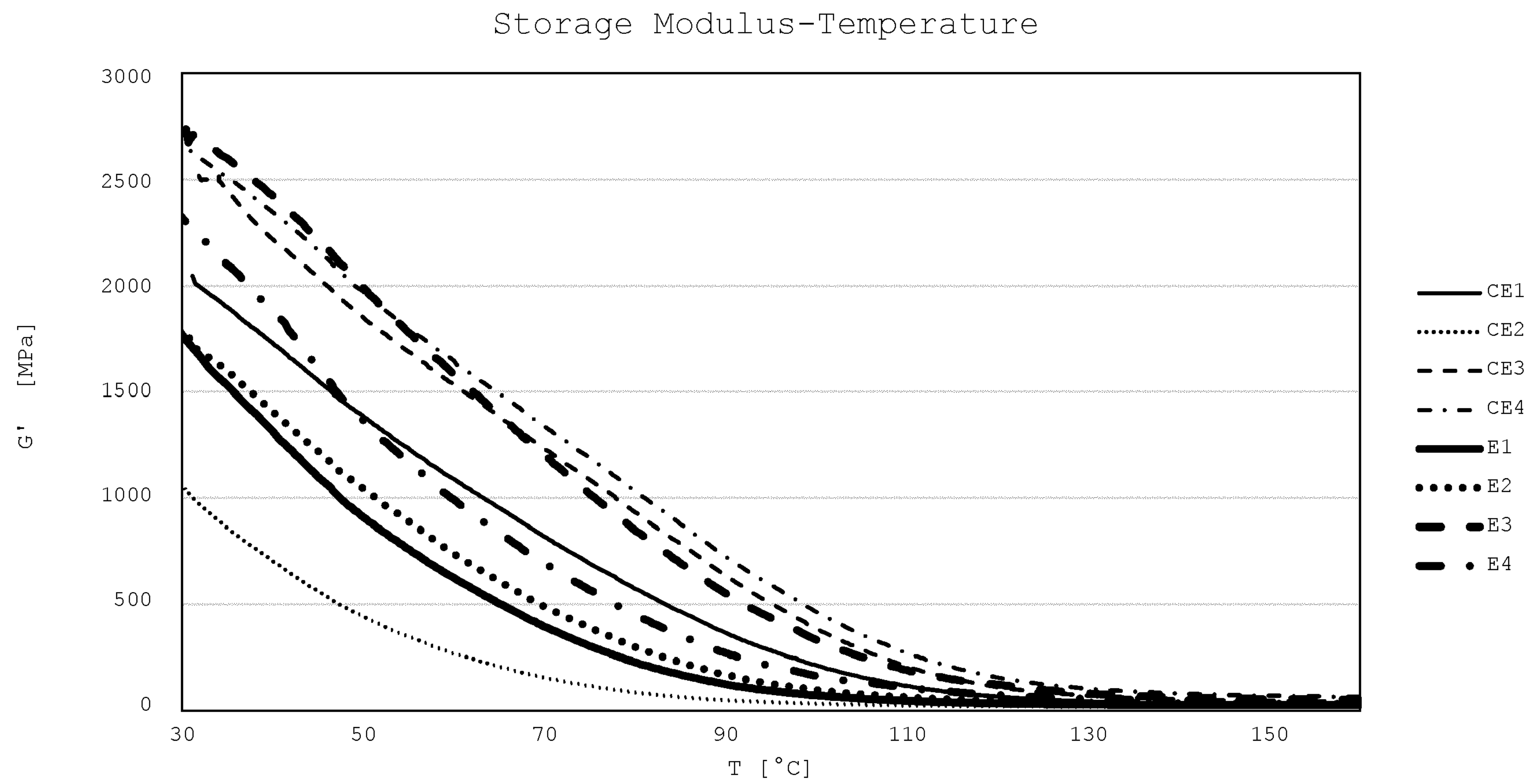


Thermo-mechanical behaviour for comparative examples CE1-CE4 and examples E1-E4.

**Fig. 4**

Europäisches Patentamt
European Patent Office
Office européen des brevets

# EUROPEAN SEARCH REPORT

Application Number
EP 22 02 0552

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 4 049 841 A1 (CUBICURE GMBH [AT]) 31 August 2022 (2022-08-31)<br>* paragraphs [0001], [0080], [0021], [0023], [0020], [0087] *<br>* paragraphs [0003], [0004], [0008], [0011] - [0030], [0040], [0042], [0045] - [0056], [0079] - [0081], [0088] - [0093], [0106] *<br>----- | 1-28 | INV.<br>G03F7/00<br>B33Y70/00<br>G03F7/027<br>G03F7/038 |
| Y | US 2011/237695 A1 (HOEROLD SEBASTIAN [DE] ET AL) 29 September 2011 (2011-09-29)<br>* paragraphs [0001], [0006], [0069]; examples 7-12; tables 1,2 *<br>* paragraphs [0007] - [0009], [0022], [0050] - [0055], [0063] - [0068] *<br>----- | 1-28 | |
| Y | US 2019/112476 A1 (PASETTI GUGLIELMO [IT] ET AL) 18 April 2019 (2019-04-18)<br>* paragraphs [0008], [0028], [0029], [0033], [0066] - [0073] *<br>----- | 1 | |
| | | | TECHNICAL FIELDS SEARCHED (IPC) |
| A | US 9 006 306 B2 (SABIC INNOVATIVE PLASTICS IP [NL]; SABIC GLOBAL TECHNOLOGIES BV [NL]) 14 April 2015 (2015-04-14)<br>* column 1, line 65 - column 2, line 57; examples 7-12; tables 1,2 *<br>* column 10, line 30 - column 11, line 19 *<br>* column 12, line 26 - line 49 *<br>----- | 1 | G03F<br>B33Y<br>C08K<br>C07C |
| A | US 8 686 072 B2 (DING TIANHUA [US]; FONSECA RODNEY [US] ET AL.) 1 April 2014 (2014-04-01)<br>* column 1, line 49 - column 3, line 47 *<br>----- | 1 | |

The present search report has been drawn up for all claims

1

| Place of search | Date of completion of the search | Examiner |
|---|---|---|
| Munich | 5 May 2023 | Loughman, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 22 02 0552

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2023

| Patent document cited in search report | Publication date | Patent family member(s) | Publication date |
|---|---|---|---|
| EP 4049841 A1 | 31-08-2022 | EP 4049841 A1 | 31-08-2022 |
| | | WO 2022180566 A1 | 01-09-2022 |
| US 2011237695 A1 | 29-09-2011 | CN 103025811 A | 03-04-2013 |
| | | CN 106674914 A | 17-05-2017 |
| | | EP 2550322 A1 | 30-01-2013 |
| | | JP 5858979 B2 | 10-02-2016 |
| | | JP 2013522425 A | 13-06-2013 |
| | | KR 20130062914 A | 13-06-2013 |
| | | TW 201211128 A | 16-03-2012 |
| | | US 2011237695 A1 | 29-09-2011 |
| | | WO 2011116906 A1 | 29-09-2011 |
| US 2019112476 A1 | 18-04-2019 | CN 111315810 A | 19-06-2020 |
| | | EP 3697838 A2 | 26-08-2020 |
| | | KR 20200062336 A | 03-06-2020 |
| | | US 2019112476 A1 | 18-04-2019 |
| | | US 2022363898 A1 | 17-11-2022 |
| | | WO 2019077529 A2 | 25-04-2019 |
| US 9006306 B2 | 14-04-2015 | CN 104379651 A | 25-02-2015 |
| | | EP 2855572 A1 | 08-04-2015 |
| | | KR 20150013674 A | 05-02-2015 |
| | | US 2013331478 A1 | 12-12-2013 |
| | | WO 2013175452 A1 | 28-11-2013 |
| US 8686072 B2 | 01-04-2014 | CN 102959010 A | 06-03-2013 |
| | | EP 2588529 A1 | 08-05-2013 |
| | | KR 20130141349 A | 26-12-2013 |
| | | US 2011319534 A1 | 29-12-2011 |
| | | WO 2012003180 A1 | 05-01-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020055682 A1
- WO 2019130306 A1
- WO 2013189821 A1
- CN 112940189 A
- CN 105068378 A
- CN 102827332 A
- KR 20210104367 A
- CN 113637118 A
- EP 3284583 A1
- EP 4049841 A1
- US 20160160077 A1
- WO 2016200972 A1
- WO 2018191247 A1


### Non-patent literature cited in the description


- *CHEMICAL ABSTRACTS,* 5945-33-5
- *CHEMICAL ABSTRACTS,* 181028-79-5
- *CHEMICAL ABSTRACTS,* 68333-79-9
- *CHEMICAL ABSTRACTS,* 225789-38-8